# EUROPÄISCHE PATENTSCHRIFT

(11) **EP 4 649 319 B1**
(45) Veröffentlichungstag und Bekanntmachung des Hinweises auf die Patenterteilung: **28.10.2026**
(21) Anmeldenummer: 23834072.3
(22) Anmeldetag: 18.12.2023
(51) Int. Cl.: G01R 31/58, H04B 3/46

(54) **VERFAHREN UND PRÜFVORRICHTUNG ZUM PRÜFEN VON ENDSTUFEN FÜR EINE BREITBANDIGE HOCHFREQUENTE POWERLINE-KOMMUNIKATION**
METHOD AND TEST APPARATUS FOR TESTING OUTPUT STAGES FOR BROADBAND HIGH-FREQUENCY POWERLINE COMMUNICATION
PROCÉDÉ ET APPAREIL DE TEST POUR TESTER DES ÉTAGES DE SORTIE POUR UNE COMMUNICATION PAR COURANTS PORTEURS HAUTE FRÉQUENCE À LARGE BANDE

(30) Priorität: 13.01.2023 DE 102023200272
(43) Veröffentlichungstag der Anmeldung: 19.11.2025
(73) Patentinhaber: VOLKSWAGEN AKTIENGESELLSCHAFT, 38440 Wolfsburg (DE)
(72) Erfinder: MENSSEN, Wolfgang, 38110 Braunschweig (DE); BARANSKI, Bernd, 22143 Hamburg (DE); JÄCKLE, Nicolas, 38176 Wendeburg (DE)
(86) Internationale Anmeldenummer: PCT/EP2023/086381
(87) Internationale Veröffentlichungsnummer: WO 2024/149575

(56) Entgegenhaltungen:
- DE-A1- 102011 056 501
- ICHRAF OUANNES ET AL: "Physical Layer Performance Analysis of Power Line Communication (PLC) applied for Cell-Wise Monitoring of Automotive Lithium-Ion Batteries", 17 October 2014 (2014-10-17), XP055317223, Retrieved from the Internet <URL:http://ieeexplore.ieee.org/ielx7/6924247/6924248/06924268.pdf?tp=&arnumber=6924268&isnumber=6924248> [retrieved on 20161108]
- OPALKO OLIVER ET AL: "Physical layer and multi-carrier analysis for power line communication networks in Li-ion batteries for electric and hybrid vehicles", 2015 IEEE VEHICULAR NETWORKING CONFERENCE (VNC), IEEE, 16 December 2015 (2015-12-16), pages 243 - 250, XP032852398, DOI: 10.1109/VNC.2015.7385583

## Beschreibung

Die Erfindung betrifft Prüfgeräte und Verfahren zum Prüfen einer Endstufe, insbesondere von Elektrofahrzeugen oder Ladestationen, für eine breitbandige hochfrequente Powerline-Kommunikation über unterschiedliche, insbesondere steckbare Kabel.

Elektrofahrzeuge besitzen in der Regel mindestens einen elektrischen Speicher in Form einer Batterie, in der elektrische Energie für das Antreiben einer elektrischen Antriebsmaschine des Elektrofahrzeug gespeichert wird. Um diesen Speicher aufzufüllen, wird das Elektrofahrzeug mittels eines Ladekabels mit der Ladestation verbunden. Das Ladekabel wird hierbei zumindest auf der Seite des Elektrofahrzeugs in der Regel mit einem Ladekabelstecker ausgebildet, der in einen Ladekabelanschluss gesteckt wird, der auch als Ladekabelbuchse bezeichnet wird.

Da die Elektrofahrzeuge (EV - electric vehicle) und Ladestationen (EVSE - electric vehicle supply equipment) unterschiedlich ausgestaltet sind, zum Beispiel hinsichtlich des Ladestroms, den die Ladestationen bereitstellen können und mit dem die Elektrofahrzeuge geladen werden können, wird auf einem Adernpaar des Ladekabels eine Kommunikation zwischen Elektrofahrzeug und Ladestation ausgeführt.

Bei Ladekabeln mit Steckern vom sogenannten TYP2 werden hierfür beispielsweise die Leitungen mit den Bezeichnungen Steuerpilot (CP - control pilot) und Schutzleiter (PEprotective earth) verwendet.

Es ist bekannt, beispielsweise eine Pulsweitenmodulation mit einem Rechteckspannungssignal auszuführen, um eine maximale Ladestromstärke, mit der der elektrische Speicher des Elektrofahrzeugs geladen werden kann, zu signalisieren.

Um auch andere Daten und insbesondere mehr Daten austauschen zu können, beispielsweise eine Abrechnung des Ladestroms automatisiert ausführen zu können, wird auf demselben Adernpaar auch eine Powerline-Kommunikation mit einem breitbandigen Hochfrequenzsignal ausgeführt. Das Hochfrequenzsignal wird beispielsweise mit einem orthogonalen Frequenzmultiplexverfahren (OFDM - orthogonal frequency division multiplexing) moduliert.

Hierbei wird die Information über eine Vielzahl von Frequenzkanälen des breitbandigen Hochfrequenzsignals übertragen.

Damit die Powerline-Kommunikation beispielsweise im Frequenzbereich von 1,8 Megahertz bis 30 Megahertz ungestört ablaufen kann, ist es notwendig, dass die Endstufen und das zur Übertragung genutzte Kabel, das Ladekabel, hinsichtlich ihrer Impedanzen über den verwendeten Frequenzbereich aufeinander abgestimmt sind.

Allgemein gilt für die benötigte Abschlussimpedanz ZE einer zu überprüfenden Endstufe der komplexe Zusammenhang: $ZE = ZA ⋅ \frac{\left(\left(cosh γ⋅l+\frac{ZL}{ZA}⋅sinh γ⋅l\right)\right)}{\left(\left(cosh γ⋅l+\frac{ZA}{ZL}⋅sinh γ⋅l\right)\right)}$ wobei *ZL* eine Leitungimpedanz, *ZL* eine Lastimpedanz, *γ* die Wellenausbreitungskonstante der Leitung, *l* die Leitungslänge bezeichnen.

Wenn die Leitungsimpedanz und die Abschlussimpedanz der Endstufe für den Nutzfrequenzbereich abgestimmt sind, gilt in diesem Bereich *ZE = ZA .*

Liegt in einer Endstufe keine korrekte Impedanzanpassung vor, so treten dort Reflexionen für einzelne oder eine Vielzahl von Frequenzen oder Frequenzbereichen auf. Diese Reflexionen können zu Resonanzen und Auslöschungen auf einzelnen oder mehreren Frequenzkanälen führen. Auf diesen Frequenzkanälen ist dann eine Informationsübertragung gestört. Diese Störungen führen beispielsweise dazu, dass ein Ladevorgang nicht begonnen werden kann oder vorzeitig abgebrochen wird.

Typischerweise findet auf dem Leitungspaar des Ladekabels somit eine OFDM-modulierte breitbandige Powerline-Kommunikation im Frequenzbereich von 1,8 MHz bis 30 MHz von 1,2 Volt Spitze-zu-Spitze (Vpp) statt, in dem 1150 Kanäle im Abstand von 24,124 kHz (Kilohertz) verwendet werden. Diesem Hochfrequenzsignal ist das pulsweitenmodulierte (PWM) Rechtecksignal mit einer Frequenz von einem kHz mit Spannungen im Bereich von plus 12 V (Volt) bis minus 12 V überlagert.

Die aus dem Stand der Technik bekannten Verfahren zum Überprüfen der korrekten Impedanzanpassung über den relevanten Frequenzbereich scheitern angesichts der beiden gleichzeitig verwendeten unterschiedlichen Übertragungsverfahren.

Bei der US 2022/0163603 A1 ist vorgesehen, ein Impedanznetzwerk zu nutzen, welches beispielsweise in einen Stecker eines Ladekabels integriert wird, welches eine bestimmte Frequenz abschwächt. Bei der Druckschrift ist vorgesehen, die korrekte Verbindung mit Ladekabel darüber zu prüfen, dass ermittelt wird, ob diese spezielle Frequenz korrekt gedämpft wird.

Die US 2016/0112135 A1 schlägt zum Vermindern von Übertragungsverlusten eine Übertragungsvorrichtung vor, die einen Sender enthält, der eine erste elektromagnetische Welle zur Datenübertragung erzeugt. Ein Koppler koppelt die erste elektromagnetische Welle an ein Einzeldraht-Übertragungsmedium mit einer Außenfläche, um eine zweite elektromagnetische Welle zu bilden, die so geführt wird, dass sie sich entlang der Außenfläche des Einzeldraht-Übertragungsmediums über mindestens eine geführte Wellenmode ausbreitet, die eine asymmetrische oder nicht-fundamentale Mode mit einer unteren Grenzfrequenz umfasst. Eine Trägerfrequenz der zweiten elektromagnetischen Welle wird so gewählt, dass sie innerhalb eines begrenzten Bereichs der unteren Grenzfrequenz liegt, so dass ein Großteil des elektrischen Feldes innerhalb eines Abstands von der Außenfläche konzentriert wird, der weniger als die Hälfte der größten Querschnittsabmessung des Ein-Draht-Übertragungsmediums beträgt, und/oder um Ausbreitungsverluste zu verringern.

Die US 2017/0018830 A1 beschreibt ein System, welches Verfahrensschritte ausführt, die eine Signalverschlechterung von geführten elektromagnetischen Wellen erkennen, die an ein Übertragungsmedium gebunden sind, ohne einen elektrischen Rückweg zu nutzen, wobei die geführten elektromagnetischen Wellen einen nicht optischen Frequenzbereich haben, und das Einstellen einer Ausrichtung von mindestens einem Teil der Felder der geführten elektromagnetischen Wellen umfassen, um die Signalverschlechterung abzuschwächen.

Aus der DE 10 2011 056 501 A1 ist ein System zur Überwachung eines Hochvoltbordnetzes eines Kraftfahrzeugs bekannt. Insbesondere wird eine Anordnung beschrieben, bei der Sensoren und eine Auswerteeinheit eingesetzt werden, um Fehlerzustände im Hochvoltsystem zu erkennen und geeignete Schutzmaßnahmen einzuleiten. Dadurch wird eine zuverlässige Detektion sicherheitsrelevanter Abweichungen im Hochvoltnetz ermöglicht.

Aus dem Dokument Ouannes et al., "Physical Layer Performance Analysis of Power Line Communication (PLC) applied for Cell-Wise Monitoring of Automotive Lithium-Ion Batteries*"* ist der Einsatz von Powerline-Kommunikation zur Reduzierung des Verkabelungsaufwands in automobilen Lithium-Ionen-Batteriesystemen bekannt. Die Veröffentlichung untersucht die physikalische Übertragungsschicht und vergleicht Einträger- und Mehrträger-Modulationsverfahren bei hochfrequenter Datenübertragung über die Batterieleitung. Dabei werden kanal- und rauschbedingte Einflüsse analysiert und die Leistungsfähigkeit der Modulationsverfahren hinsichtlich Robustheit und Bitfehlerrate bewertet. Der Erfindung liegt die technische Aufgabe zugrunde, ein verbessertes Verfahren und eine Vorrichtung sowie ein System anzugeben, mit denen eine Endstufe, insbesondere eine entfernte, über ein Kabel angeschlossene oder anzuschließende Endstufe, hinsichtlich einer korrekten Impedanzanpassung für eine Signalübertragung überprüft werden kann.

Die Aufgabe wird durch ein Verfahren mit den Merkmalen des Patentanspruchs 1, eine Prüfvorrichtung mit den Merkmalen des Patentanspruchs 9 sowie ein System mit den Merkmalen des Patentanspruchs 14 erfindungsgemäß gelöst. Vorteilhafte Ausgestaltungen der Erfindung ergeben sich aus den Unteransprüchen.

Der Erfindung liegt die Idee zugrunde, ein breitbandiges Hochfrequenzsignal, wie es bei der Powerline-Kommunikation verwendet wird und in der Regel zum Beginn einer Powerline-Kommunikation erzeugt und welches über ein Kabel von der Endstufe, die geprüft werden soll, übertragen wird, auszuwerten. Das übertragene Signal wird abgetastet, um mindestens einen Zeittransienten zu erfassen. Anhand dieses mindestens einen Zeittransienten wird ein spektrales Leistungsdichtespektrum ermittelt, welches auch als Power Spectral Density (PSD) im Stand der Technik bezeichnet wird. Das spektrale Leistungsdichtespektrum ist die gegen die Frequenz aufgetragene spektrale Leistungsdichte des übertragenen Signals, die pro Frequenzbandbreite übertragen ist. Definitionsgemäß ist die Frequenzbandbreite hier infinitesimal zu wählen. Praktisch wird jedoch in der Regel ein Leistungsdichtespektrum mit Werten angegeben, die auf eine vorgewählte endliche Bandbreite, eine Auflösungsbandbreite, die im Englischen als Resolution Bandwidth (RBW) bezeichnet ist, bezogen ist. Die spektrale Leistungsdichte lässt sich mathematisch auch als Fouriertransformierte der Autokorrelationsfunktion eines zeitabhängigen übertragenen Signals auffassen. Deshalb wird das spektrale Leistungsdichtespektrum auch als Autoleistungsspektrum bezeichnet. Indem einzelne Frequenzbereiche des spektralen Leistungsdichtespektrums, d.h. des PSD-Spektrums, ausgewertet werden, kann ermittelt werden, ob in diesen Abschnitten Störungen aufgrund von Reflexionen auftreten, die eine Kommunikation stören, oder nicht.

Insbesondere wird somit ein Verfahren zum Prüfen von Endstufen, insbesondere von Elektrofahrzeugen oder Ladestationen, für eine breitbandige hochfrequente Powerline-Kommunikation über Kabel, geschaffen,umfassend die Schritte:
a) Verbinden der zu prüfenden Endstufe und einer Prüfvorrichtung mit einem der Kabel,
b) Festlegen einer Abschlussimpedanz des Kabels an oder in der Prüfvorrichtung
c) Abtasten eines auf dem einen der Kabel von der zu prüfenden Endstufe übertragenen breitbandigen Hochfrequenzsignals, das in jedem für die Hochfrequenzkommunikation genutzten Frequenzbereich des breitbandigen Hochfrequenzsignals mit einer konstanten spektralen Leistungsdichte erzeugt wird, gemäß dem Nyquist-Shannon-Abtasttheorem an der der Prüfvorrichtung zugeordneten Ende des einen der Kabel und Erfassen mindestens eines Zeittransienten, beides während des Übertragens des breitbandigen Hochfrequenzsignals,
d) Ermitteln eines dem einen der Kabel und der festgelegten Abschlussimpedanz zugeordneten spektralen Leistungsdichtespektrums anhand des mindestens einen unter Verwendung des einen der Kabel für die festgelegte Abschlussimpedanz erfassten Zeittransienten
e) Auswerten des einen oder der mehreren für die Kommunikation genutzten Frequenzbereiche des spektralen Leistungsdichtespektrums,
f) wobei im Schritt b) die Abschlussimpedanz auf einen Wert festgelegt wird, der an eine Impedanz der Kabel angepasst ist und im Schritt e) beim Auswerten geprüft wird, ob Abweichungen in einem oder mehreren Bereichen des spektrales Leistungsdichtespektrums gegenüber einem spektralen Leistungsdichtespektrum auftreten, das bei Kommunikation mit einer korrekt hinsichtlichder Impedanzangepassten Endstufe erwartet wird oder erfasst ist, und
g) Ausgeben eines Ergebnisses der Auswertung, das zumindest eine Angabe über eine Korrektheit der Impedanzanpassung oder Unkorrektheit der Impedanzanpassung der zu prüfenden Endstufe umfasst.

Wird in den Frequenzbereichen, die für die Übertragung von Informationen bei einer Powerline-Kommunikation genutzt werden, eine Überhöhung und/oder ein Absinken der spektralen Leistungsdichte gegenüber einer erwarteten spektralen Leistungsdichte (gegebenenfalls bezogen auf eine Bandbreitenauflösung) festgestellt, so kann darauf zurückgeschlossen werden, dass eine Fehlanpassung vorliegt. Sinkt die spektrale Leistungsdichte bei mehr als 40% des gesamten Übertragungsspektrums zu stark ab, ist davon auszugehen, dass die Kommunikation nicht störungsfrei ablaufen kann. In Bereichen der Überhöhung können Vorschriften der elektromagnetischen Verträglichkeit verletzt werden.

Entsprechend wird eine Prüfvorrichtung zum Prüfen von Endstufen, insbesondere von Elektrofahrzeugen oder Ladestationen, für eine breitbandige hochfrequente Powerline-Kommunikation über Kabel, umfassend:
einen Kabelanschluss zum Anschließen eines Endes eines der Kabel, das mit einem anderen Ende mit der zu prüfenden Endstufe verbunden ist ;
eine mit dem Kabelanschluss verbundene Kabelabschlusseinrichtung, zum Festlegen einer Abschlussimpedanz der mit dem Kabelanschluss verbunden Leitung an oder in der Vorrichtung zum Prüfen;
eine mit dem Kabelanschluss verbundene Abtasteinrichtung zum Abtasten des auf dem einen der Kabel übertragenen breitbandigen Hochfrequenzsignals gemäß dem Nyquist-Shannon-Abtasttheorem und Erfassen mindestens eines Zeittransienten, beides während des Übertragens des breitbandigen Hochfrequenzsignals;
eine Berechnungseinheit zum Ermitteln eines dem einen der Kabel zugeordneten spektralen Leistungsdichtespektrums anhand des mindestens einen unter Verwendung des einen der Kabel erfassten Zeittransienten, und
eine Auswerteeinrichtung zum Auswerten eines oder mehrerer Frequenzbereiche des spektralen Leistungsdichtespektrums,
wobei beim Auswerten geprüft wird, ob Abweichungen in einem oder mehreren Frequenzbereichen des spektralen Leistungsdichtespektrums gegenüber einem spektralen Leistungsdichtespektrum auftreten, das bei einer Kommunikation mit einem korrekt hinsichtlich der Impedanz angepassten Endstufe erwartet wird oder erfasst ist, und
eine Ausgabeeinrichtung, welche ein Ergebnis der Auswertung ausgibt, welche zumindest eine Angabe über eine Korrektheit oder Unkorrektheit der Impedanzanpassung der zu prüfenden Endstufe ausgibt.

Ein System umfasst eine Ausführungsform der beschreibenen Prüfvorrichtung sowie einen Satz unterschiedlich langer Kabel.

Das Ergebnis der Überprüfung ist jeweils eine Aussage darüber, ob die zu überprüfende Endstufe eine Gewähr dafür bietet, dass sie, wenn sie mit einem üblicherweise dem Stand der Technik entsprechenden Kabel verwendet wird, eine ungestörte Kommunikation aufgrund einer korrekten Impedanzanpassung ermöglichen wird oder ob Störungen im Betrieb aufgrund einer nicht korrekten Impedanzanpassung zu erwarten sind.

Die Auswertung kann ohne eine konkrete Kenntnis eines spektralen Leistungsdichtespektrum einer Powerline-Kommunikation mit korrekt hinsichtlich der Impedanz angepassten Endstufen erfolgen. Schwankungen oberhalb eines Schwellenwertes treten bei korrekt abgestimmten Endstufen nicht auf. Bei einer Ausführungsform ist daher vorgesehen, dass das Prüfen im Verfahrensschritt e), ob Abweichungen dem in einem oder mehreren Bereichen des spektrales Leistungsdichtespektrums gegenüber einem spektralen Leistungsdichtespektrum auftreten, das bei einer Kommunikation mit einem korrekt hinsichtlich der Impedanz angepassten Endstufe erwartet wird oder erfasst ist, umfasst, dass geprüft wird, , ob in einem ermittelten spektralen Leistungsdichtespektren Schwankungen der spektralen Leistungsdichte oberhalb eines Schwellenwertes auftreten.

Da das Auftreten von Reflexionen und Resonanzen von einer Länge des verwendeten Kabels anhängig ist, ist bei einer bevorzugten Weiterbildung vorgesehen, dass das Übertragen des Hochfrequenzsignals, dessen Abtasten und Ermitteln des dem Kabel zugeordneten spektralen Leistungsdichtespektrums auch für ein weiteres der Kabel durchgeführt wird, welches eine abweichende Länge von dem einen, zuerst gewählten, der Kabel hat. Ist die Endstufe hinsichtlich der Impedanz korrekt angepasst, so gibt es im spektralen Leistungsdichtespektrum keine Unterschiede, die von der jeweils zugeordneten Kabellänge abhängen. Dies bedeutet, dass die spektralen Leistungsdichtespektren für die unterschiedlichen verwendeten Kabellängen im Rahmen statistischer Variationen gleich sind. Die Auswertung kann somit darüber erfolgen, dass geprüft wird, ob die für die unterschiedlich langen Kabel ermittelten spektralen Leistungsdichtespektren zumindest in einzelnen Frequenzbereichen Abweichungen aufzeigen. Idealerweise ist die Differenz über den gesamten Frequenzbereich, welcher für die breitbandige Powerline-Kommunikation verwendet wird, unter Berücksichtigung der Änderung der Dämpfung, die durch die bekannte Dämpfung des Kabels verursacht ist, innerhalb von Toleranzgrenzen Null.

Auf eine korrekte Anpassung der Impedanz kann bei einer Ausführungsform somit daraus geschlossen werden, dass die ermittelte Differenz der spektralen Leistungsdichtespektren für unterschiedlich lange Kabel Null oder die spektralen Leistungsdichtespektren zumindest innerhalb einer Toleranzgrenze nicht verschieden sind.

Die Auswertung kann vereinfacht werden, indem Mittelwerte der spektralen Leistungsdichtespektren ausgewertet werden.

Eine Ausführungsform sieht daher vor, dass die Schritte a) bis d) zusätzlich unter Verwendung mindestens ein anderes der Kabels ausgeführt werden, wobei das mindestens eine andere der Kabel eine von dem mindestens einen der Kabel abweichende Länge aufweist, und die Abschlussimpedanz im Schritt b) identisch festgelegt wird, wie beim Ausführen der Schritte a) bis d) für das mindestens eine der Kabel und dass das Auswerten des Schritts e) umfasst, dass für die ermittelten spektralen Leistungsdichtespektren jeweils eine mittlere spektrale Leistungsdichte über die für die Powerline-Kommunikation genutzten Frequenzbereiche berechnet wird, die Mittelwerte paarweise für spektrale Leistungsdichtespektren verglichen werden, die für unterschiedliche Kabellängen, aber dieselbe Abschlussimpedanz erfasst sind, und die zu prüfende Endstufe als nicht korrekt abgestimmt eingestuft, wenn hierbei Abweichungen oberhalb eines Mittelwertschwellenwertes auftreten.

Eine Ausführungsform sieht vor, dass die Schritte a) bis d) zusätzlich unter Verwendung mindestens eines anderen der Kabel ausgeführt werden, wobei das mindestens eine andere der Kabel eine von dem mindestens einen der Kabel abweichende Länge aufweist, und die Abschlussimpedanz im Schritt b) identisch festgelegt wird, wie beim Ausführen der Schritte a) bis d) für das mindestens eine der Kabel und dass das Auswerten des Schritts e) umfasst,. dass für die ermittelten spektralen Leistungsdichtespektren jeweils eine mittlere spektrale Leistungsdichte über die für die Powerline-Kommunikation genutzten Frequenzbereiche berechnet wird, die Mittelwerte paarweise für spektrale Leistungsdichtespektren verglichen werden, die für unterschiedliche Kabellängen, aber dieselbe Abschlussimpedanz erfasst sind, und die zu prüfende Endstufe als nicht korrekt abgestimmt eingestuft wird, wenn hierbei Abweichungen oberhalb eine Mittelwertschwellenwertes auftreten.

Wenn man die Verfahren erweitert, kann sogar die Impedanz der zu prüfenden Endstufe, die nicht korrekt abgestimmt ist, abgeschätzt werden. Hierfür ist es vorteilhaft, die Abtastung und Auswertung nicht nur für verschiedene Kabellängen bei demselben Abschluss der Leitung an oder in der Prüfvorrichtung durchzuführen, sondern die Abtastung und Auswertung zusätzlich auch für verschiedene Abschlüsse der Leitung auszuführen. D.h., sowohl die Kabellänge wird variiert als auch die Abschlussimpedanz der Leitung verändert. Für mindestens zwei unterschiedliche Abschlüsse der Leitung am oder in der Prüfvorrichtung hinsichtlich der Impedanz werden Übertragungen der zu prüfenden Endstufe für unterschiedliche lange Leitungen abgetastet und ausgewertet. Hierbei wird jeweils eine Übertragung abgetastet und ausgewertet, bei der Ausschließlich von der zu prüfenden Endstufe ein breitbandiges Hochfrequenzsignal übertragen wird, dessen spektrale Leistung über den Frequenzbereich, der zur Powerline-Kommunikation genutzt wird, gleich verteilt ist. Es zeigt sich, dass die auf die Änderung der Kabellänge zurückzuführende Differenz der Mittelwerte im Wesentlichen unabhängig von dem gewählten Abschluss der Leitung in oder an der Prüfvorrichtung ist. Diese Differenz, die aus Mittelwerten für unterschiedliche Kabellängen, aber denselben Leitungsabschluss ermittelt ist, ist, zumindest wenn sie einer Differenz gleicht, die für einen anderen Leitungsabschluss hinsichtlich der Impedanz ermittelt ist, ein Maß für die Impedanz der nicht korrekt angepassten zu prüfenden Endstufe.

Tritt eine Differenz, die anhand von zwei Mittelwerten der spektralen Leistungsdichte für unterschieldiche Kabellängen, aber denselben Leitungsabschluss gebildet ist, oberhalb einer vorfestgelegten Toleranzschwelle auf, so hat es sich gezeigt, dass in guter Näherung die Impedanz der Endstufe Z_{E} für die jeweilige Frequenz gegeben ist durch folgende Gleichung: ${Z}_{E} = Differenz \times {Z}_{A}$ wobei die Differenz aus der physikalischen Einheit dBm/Hz in einen Faktor umzurechnen ist und Z_{A} die Impedanz des verwendeten Kabels ist.

Gemäß einer bevorzugten Ausführungsform des Verfahrens werden daher die Verfahrensschritte a) bis d) für mehrere der Kabel mit einer unterschiedlichen Länge ausgeführt, wobei die Schritte a) bis d) für jedes der mehreren Kabel mindestens zwei Mal durchgeführt werden, wobei hierbei im Verfahrensschritt b) unterschiedliche Abschlussimpedanzen festgelegt werden, und beim Auswerten im Verfahrensschritt e) die Differenzen der mittleren spektralen Leistungsdichten der für verschiedene Kabellängen, aber identische Abschlussimpedanzen ermittelten spektralen Leistungsdichtespektren für mindestens zwei der unterschiedlich festgelegten Abschlussimpedanzen verglichen werden, und wenn diese Differenzen der Mittelwerte im Rahmen einer Toleranz gleich, aber von Null verschieden sind, anhand der Differenz die Abschlussimpedanz der zu prüfenden Endstufe abgeschätzt wird, indem die Differenz in einen Faktor umgerechnet wird und mit der Impedanz der Kabel multipliziert wird.

Das Festlegen der Abschlussimpedanz auf einen Wert, der an eine Impedanz der Kabel angepasst ist, erfolgt bei einer bevorzugten Ausführungsform, indem eine mit dem entsprechenden der Kabel verbundenen Leitung in oder an der Prüfvorrichtung über einen ohmschen Abschlusswiderstand abgeschlossen wird, dessen Wert der Impedanz der Leitung der Kabel entspricht, oder indem das entsprechende der Kabel über die Leitung mit einer anderen Endstufenschaltung einer Hochfrequenzsende- und Empfangseinheit verbunden wird, die hinsichtlich der Impedanz über den gesamten für die Powerline-Kommunikation genutzten Frequenzbereich korrekt abgestimmt ist und hinsichtlich einer eignen Aussendung während des Empfangs des Hochleistungssignals der zu prüfenden Endstufe bedämpft ist.

Die verwendeten Kabel umfassen vorzugweise eine Zweidrahtleitung für die Powerline Kommunikation. Ein bevorzugte Ausführungsform des Systems sieht somit vor, dass die Kabel mit Zweidrahtleitungen für die Powerline-Kommunikation bereitgestellt werden und deren Impedanz 100 Ohm beträgt. Entsprechend wird bevorzugt als ein an die Impedanz der Kabel angepasster Abschlusswiderstand ein ohmscher Widerstand von 100 Ohm verwendet.

Eine Ausführungsform der Prüfvorrichtung sieht vor, dass die Kabelabschlusseinrichtung einen ohmschen Abschlusswiderstand umfasst, der der Impedanz der Kabel entspricht.

Werden unterschiedliche Abschlussimpedanzen benötigt, so wird vorzugsweise eine Abschlussimpedanz verwendet, die an die Impedanz der Kabels angepasst ist. Eine hierzu unterschiedliche Impedanz wird vorzugsweis mit einem großen Impedanzunterschied zu der Impedanz der Kabel gewählt. Bevorzugt wird eine unendliche Impedanz oder nahezu unendliche Impedanz gewählt. Diese kann eingestellt und festgelegt werden, indem die mit dem entsprechenden der Kabel in der Prüfvorrichtung verbundene Leitung in oder an der Prüfvorrichtung unterbrochen, das heißt, geöffnet wird. Beispielsweise kann eine Verbindung mit einer offenen Leitung hergestellt werden.

Eine bevorzugte Ausführungsform sieht daher vor, dass die im Verfahrensschritt b) festgelegten unterschiedlichen Impedanzen eine unendliche Impedanz umfassen, die festgelegt wird, indem die mit dem entsprechenden der Kabel verbundene Leitung in oder an der Prüfvorrichtung geöffnet wird.

Bei einer Ausführungsform der Prüfvorrichtung kann die Kabelabschlusseinrichtung eine Umschalteinrichtung umfassen, um die Leitung in oder an der Vorrichtung zum Prüfen, über den Abschlusswiderstand, der der Impedanz der Kabel entspricht, abzuschließen, oder in einen offenen Zustand zu schalten, um eine unendliche Impedanz zu simulieren, oder mit einer korrekt hinsichtlich der Impedanz angepassten Endstufe einer Hochfrequenzsende- und Empfangseinheit einer Powerline-Kommunikationseinrichtung zu verbinden, um eine optimale Anpassung des Kabelabschlusses herzustellen.

Ausführungsformen können nur zwei der drei hier vorgestellten Möglichkeiten umfassen.

Beispielsweis kann zwischen einem ohmschen Abschlusswiderstand und einer geöffneten Leitung umgeschaltet werden.

Die Zuverlässigkeit des ermittelten Ergebnisses kann dadurch weiter gesteigert werden, dass bei einer Ausführungsform vorgesehen ist, dass die iterierten Verfahrensschritte für mehr als zwei Kabeln ausgeführt werden, die alle eine unterschiedliche Länge aufweisen.

Ebenso kann eine weitere Verbesserung der Zuverlässigkeit erreicht werden, wenn die iterierten Verfahrensschritte für mindestens drei Abschlussimpedanzen ausgeführt werden. Vorzugsweise werden ein an die Impedanz der Kabel angepasster ohmscher Abschlusswiderstand, eine offene Leitung für den unendlichen Widerstand und die Verbindung mit einer korrekt abgestimmten Endstufe einer Powerline-Kommunikationseinrichtung als drei verschiedene Abschlussimpedanzen verwendet.

Eine Optimale Überprüfung ist möglich, wenn das Abtasten und Auswerten für einen Abschluss des Kabels erfolgt, der über eine korrekt hinsichtlich der Impedanz angepasste Endstufe einer Powerline-Kommunikationseinrichtung ausgebildet ist, indem diese mit der Leitung verbunden wird, die in der Prüfvorrichtung mit dem Kabel verbunden ist und mit dem die Abtasteinrichtung gekoppelt ist.

Die Auswertevorrichtung ist entsprechend angepasst, um diese verbesserten Auswerteverfahren auszuführen.

Es soll an dieser Stelle hervorgehoben werden, dass das für die Prüfung benötigte breitbandige Hochfrequenzsignal der zu prüfenden Endstufe, welches mit einer konstanten spektralen Leistungsdichte erzeugt und ausgesandt wird, in der Regel im Rahmen eines Kommunikationsprotokolls einer Powerline-Kommunikation erzeugt wird. Viele Ladestationen senden ein solches, in der Regel zeitlich begrenztes breitbandiges Hochfrequenzsignal in regelmäßigen Abständen aus, um eine Initiierung einer Powerline-Kommunikation zu erleichtern.

Bei anderen Ausführungsformen kann vorgesehen sein, dass zu der zu prüfenden Endstufen für eine breitbandige hochfrequente Powerline-Kommunikation eine Signal, welches auch als Initiierungssignal bezeichnet werden kann, übertragen wird, um die Aussendung des breitbandigen Hochfrequenzsignals auszulösen, das in jedem für die Hochfrequenzkommunikation genutzten Frequenzbereich des breitbandigen Hochfrequenzesignals mit einer konstanten spektralen Leistungsdichte erzeugt wird.

Bei einer bevorzugten Weiterbildung der Vorrichtung ist vorgesehen, dass die Prüfvorrichtung Bestandteil einer Powerline-Kommunikationseinrichtung ist. Das Initiierungssignal kann dann einfach von der Powerline-Kommunikationseinrichtung erzeugt werden. Um die Messung der Antwort der zu prüfenden Endstufe nicht zu stören, wird die das Initiierungssignal aussendende Endstufe anschließend bedämpft, das heißt, verhindert, dass diese Hochfrequenzsignale erzeugt und auf die Leitung und hierüber auf das entsprechende der Kabel einspeist, über das die Verbindung mit der zu prüfenden Endstufe hergestellt ist.

Die Powerline Kommunikationseinrichtung und die Prüfvorrichtung können eigenständige Einheiten oder eine integrierte einstückige Einheit sein. Wenn die Prüfvorrichtung Bestandteil einer Powerline-Kommunikationseinrichtung ist, kann diese auch in einem Elektrofahrzeug oder einer Ladesäule realisiert sein.

Das für die Abtastung benötigte Signal mit gleichmäßiger spektraler Leistungsdichte kann erzeugt werden, indem eine geeignete Information übertragen wird, die eine möglichst gleichmäßige Verteilung der spektralen Leistungsdichte über den gesamten breitbandigen Hochfrequenzbereich bewirkt.

Besonders bevorzugt wird als Modulationsverfahren ein orthogonales Frequenzmultiplexverfahren eingesetzt. Bei diesem wird die Information auf gleich beabstandeten Frequenzkanälen übertragen, die über den zur Kommunikation verwendeten Frequenzbereich gleichmäßig gleichbeabstandet verteilt sind.

Bei einer anderen Ausführungsform ist vorgesehen, dass das Hochfrequenzsignal mit einer gleichverteilten spektralen Leistungsdichte im Rahmen einer zur Berechnung des spektralen Leistungsdichtespektrums verwendeten Auflösungsbandbreite gemäß Verfahrensschritt d) erzeugt wird. Dies bedeutet, dass in Frequenzabschnitten, deren Breite der Auflösungsbandbreite für die Erzeugung des spektralen Leistungsdichtespektrums entspricht, im Sendesignal jeweils dieselbe Sendeleistung ausgesandt wird.

Dies wird beispielsweise in einem orthogonal frequenzmultiplex modulierten Signal erreicht, wenn in jedem der dabei verwendeten Frequenzkanäle, die gleich beabstandet sind, dieselbe Information gesendet wird, die einer maximal abgestrahlten Sendeleistung in dem entsprechenden Frequenzkanal entspricht.

Die Ausgabeeinrichtung kann beispielsweise eine Anzeige oder auch eine akustische Einrichtung sein, die ein akustisches Signal ausgibt, welches die korrekte Anpassung bzw. die nicht korrekte Anpassung signalisiert. Wird anhand der Differenzbildung der ermittelten spektralen Leistungsdichte auf die Abweichung der Impedanzanpassung rückgeschlossen, so umfasst die Ausgabeeinrichtung vorzugsweise eine digitale Anzeigeeinrichtung oder auch ein analoges Anzeigegerät. Bei anderen Ausführungsformen kann die Ausgabeeinrichtung alternativ und/oder zusätzlich als Schnittstelle ausgebildet sein, über die ein digitales und/oder optisches Signal ausgegeben wird, in dem das Ergebnis der Auswertung kodiert ist. Insbesondere kann dies eine Netzwerkschnittstelle sein, beispielsweise für eine drahtlose Kommunikation per WLAN oder Bluetooth.

Eine Vorrichtung zum Prüfen bildet gemeinsam mit einem, vorzugsweise mehreren, Kabeln verschiedener Länge ein System. Man erhält somit ein System zum Prüfen von Endstufen, insbesondere von Elektrofahrzeugen oder Ladestationen für eine breitbandige hochfrequente Powerline-Kommunikation hinsichtlich ihrer Impedanzanpassung.

Nachfolgend wird die Erfindung unter Bezugnahme auf eine Zeichnung näher erläutert. Hierbei zeigen:
- Fig. 1: eine schematische Darstellung einer Prüfvorrichtung zum Prüfen einer Endstufe auf ihre Impedanzanpassung;
- Fig. 2: ein schematisches Ablaufdiagramm eines Verfahrens zum Prüfen einer Endstufe für eine Powerline-Kommunikation hinsichtlich der Impedanzanpassung;
- Fig. 3: eine schematische Darstellung eines Leistungsdichtespektrums einer korrekt angepassten Endstufe;
- Fig. 4: ein spektrales Leistungsdichtespektrum einer korrekt abgestimmten Endstufe, bei der eine Übertragung über ein doppelt so langes Kabel wie bei der Ausführungsfrom nach Fig. 3 verwendet ist;
- Fig. 5: ein spektralen Leistungsdichtespektrum korrespondierend zu dem der Fig. 3, welches mit einer korrekt abgestimmten Endstufe, jedoch einem "offenen" Abschlusswiderstand an oder in der Prüfvorrichtung aufgenommen ist;
- Fig. 6: ein spektralen Leistungsdichtespektrum korrespondierend zu dem der Fig. 4, welches mit einer korrekt abgestimmten Endstufe, jedoch einem "offenen" Abschlusswiderstand an oder in der Prüfvorrichtung aufgenommen ist;
- Fig. 7: ein spektrale Leistungsdichtespektren analog zu dem der Fig. 3, wobei die zu prüfende Endstufe nicht korrekt hinsichtlich der Impedanz angepasst ist, das Kabel an der Prüfvorrichtung jedoch korrekt abgeschlossen ist;
- Fig. 8: ein spektrale Leistungsdichtespektren analog zu dem der Fig. 4, wobei die zu prüfende Endstufe nicht korrekt hinsichtlich der Impedanz angepasst ist, das Kabel an der Prüfvorrichtung jedoch korrekt abgeschlossen ist und das Kabel doppelt so lang wie bei den Fig. 3, 5 und 7 ist;
- Fig. 9: ein spektrale Leistungsdichtespektren analog zu dem der Fig. 5, wobei die zu prüfende Endstufe nicht korrekt hinsichtlich der Impedanz angepasst ist und das Kabel an oder in der Prüfvorrichtung offen ist; und
- Fig. 10: ein spektrale Leistungsdichtespektren analog zu dem der Fig. 6, wobei die zu prüfende Endstufe nicht korrekt hinsichtlich der Impedanz angepasst ist und das Kabel an oder in der Prüfvorrichtung offen ist, wobei das Kabel doppelt so lang wie bei den Fig. 3, 5, 7 und 9 ist.

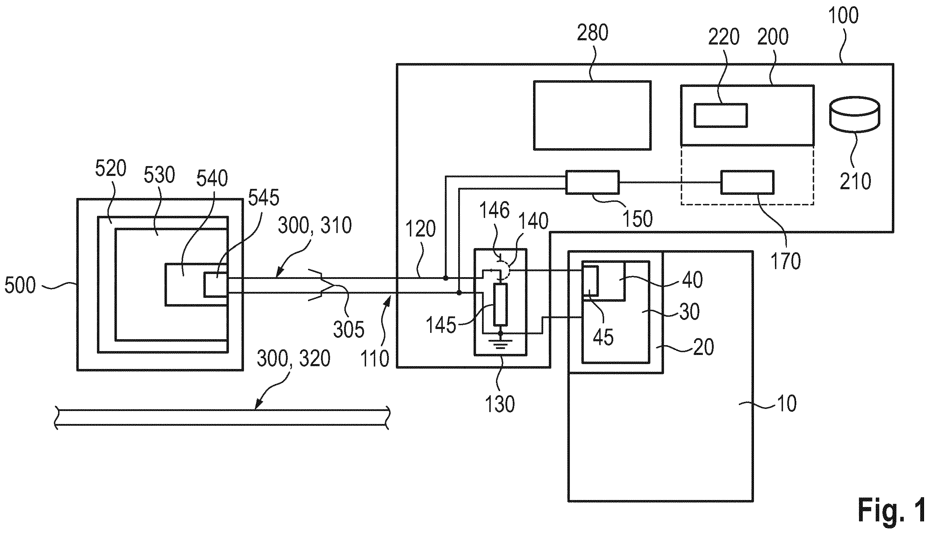

In Fig. 1 ist schematisch eine Prüfvorrichtung 100 zum Prüfen einer Endstufe 545 im Hinblick auf eine Impedanzanpassung für eine Powerline-Kommunikation schematisch dargestellt. Die Prüfvorrichtung kann beispielsweise eine gesonderte Prüfvorrichtung sein oder auch Bestandteil eines Elektrofahrzeugs 10 oder einer anderen Einrichtung sein. Im dargestellten Beispiel ist die Vorrichtung 100 Bestandteil eines Elektrofahrzeugs 10. Die zu prüfende Endstufe 545 einer Powerline-Kommunikationseinrichtung 530 ist Bestandteil einer Hochfrequenzsende- und Empfangseinheit 540. Diese ist ausgebildet, eine Powerline-Kommunikation mit einem breitbandigen Hochfrequenzsignal auszuführen. Beispielsweise wird die Powerline-Kommunikation im Frequenzbereich von1,8 MHz (Megahertz) bis 30 MHz und mit einem orthogonalen Frequenzmultiplexmodulationsverfahren (OFDM) ausgeführt. Es können Frequenzbänder in dem Bereich ausgespart sein.

Die Powerline-Kommunikationseinrichtung 530 ist wiederum Bestandteil einer Kommunikationseinrichtung 520, über die neben der Powerline-Kommunikation auch eine niederfrequente Kommunikation mit einer Pulsweitenmodulation ausgeführt wird.

Die zu prüfende Endstufe 545 könnte auch Bestandteil einer anderen Kommunikationseinrichtung eines Elektrofahrzeugs oder einer anderen Einrichtung sein, die beispielsweise zu einer Ladeinfrastruktur für Elektrofahrzeuge gehört.

Die Prüfvorrichtung 100 und die Endstufe 545 sind über ein Ladekabel 310 von mehreren Ladekabeln 300, die unterschiedliche Längen aufweisen, miteinander verbunden. Die Kabel 300 umfassen vorzugsweise eine Zweidrahtleitung 305 für die Powerline-Kommunikation als auch die niederfrequente Kommunikation. Die Kabel können weitere Leitungen für das Laden umfassen. Hier sind beispielsweise die Ladekabel 300 alle für dieselbe Impedanz, beispielsweise von 100 Ω, ausgelegt und weisen eine Dämpfung von etwa -0,33 dB/m auf.

Die Prüfvorrichtung 100 umfasst einen Kabelanschluss 110, an dem das Ladekabel 310 abgeschlossen ist.

Um zu prüfen, ob die Endstufe 545 hinsichtlich der Impedanz korrekt abgestimmt ist, weist die Prüfvorrichtung 100 eine Abtasteinrichtung 150 auf. Die Abtasteinrichtung 150 ist hierfür mit einer Leitung 120 gekoppelt, die mit dem Kabelanschluss 110 verbunden ist. Die Abtasteinrichtung 150 ist in der Lage, das über das Ladekabel 310 übertragene breitbandige Hochfrequenzsignal der Hochfrequenzsende- und Empfangseinheit 40 abzutasten, während über das Ladekabel 310 das breitbandige Hochfrequenzsignal übertragen wird. Hierbei erfolgt die Abtastung mit einer Abtastrate, die mindestens doppelt so hoch wie die höchste Frequenz, die in dem breitbandigen Hochfrequenzsignal für die Informationsübertragung auftritt. Beim Abtasten wird ein Zeittransient erfasst.

Ob auf dem Kabel 310, beispielsweise der Zweidrahtleitung 305 des Kabels 310, Reflexionen auftreten, ist von der Abstimmung der zu prüfenden Endstufe 545 und dem Abschluss des Kabels 310 oder der in der Prüfvorrichtung 100 hiermit verbundenen Leitung 120. Die Prüfvorrichtung weist hierfür eine Kabelabschlusseinrichtung 130 auf, um die Abschlussimpedanz in oder an der Prüfvorrichtung festzulegen. In der dargestellten Ausführungsform umfasst die Kabelabschlusseinrichtung 130 einen ohmschen Abschlusswiderstand 145. Dieser ist an die Leitungsimpedanz der Kabel 300 angepasst. Wenn diese für die Kommunikation jeweils eine Zweidrahtleitung 305 umfassen, welche eine Leitungsimpedanz von 100 Ohm aufweisen, so ist eine ohmscher Abschlusswiderstand 145 von 100 Ohm an die Leitungsimpedanz angepasst.

Wenn das Kabel 310 während der Messung angepasst an die Impedanz dessen Leitungsimpedanz in der Prüfvorrichtung 100 mit dem ohmschen Abschlusswiderstand 145 abgeschlossen ist, so dürfen bei einer korrekt hinsichtlich der Impedanz angepassten zu prüfenden Endstufe 545 keine Reflexionen auf dem Kabel 310 entstehen.

Die bei der Abtastung gewonnenen Daten des Zeittransienten werden in einer Berechnungseinheit 170 genutzt, um ein spektrales Leistungsdichtespektrum zu errechnen. In der Regel wird hier die Berechnung bezogen auf eine vorgegebene Frequenzbandbreite, eine Auflösungsbandbreite (RWB), vorgenommen. Nutzt die Powerline-Kommunikation Frequenzen im Bereich von 1,8 MHz bis 30 MHz, wird beispielsweise eine Auflösungsbandbreite für die Auswertung von 10 kHz gewählt.

Bei der Powerline-Kommunikation der Ladeinfrastruktur von Elektrofahrzeugen wird ein orthogonales Frequenzmultiplexmodulationsverfahren genutzt (OFDM - Orthogonal Frequency Division Multiplexing), bei dem 1.150 Träger im Abstand von 24,124 kHz genutzt werden. Diese verteilen sich über den Frequenzraum von 1,8 MHz bis 30 MHz. Die kapazitiv auf das Ladekabel 310 eingekoppelte Spannung beträgt nominal 1,2 Volt Spitze zu Spitze (Vpp). Zusätzlich wird über das Ladekabel eine niederfrequente Kommunikation mit einem pulsweitenmodulierten Signal ausgeführt, welches eine Rechteckspannung von 1 kHz mit einer Spannung von +/-12 V nutzt. Die hieran beteiligten und benötigten Komponenten sind hier aus Gründen der Vereinfachung nicht extra dargestellt.

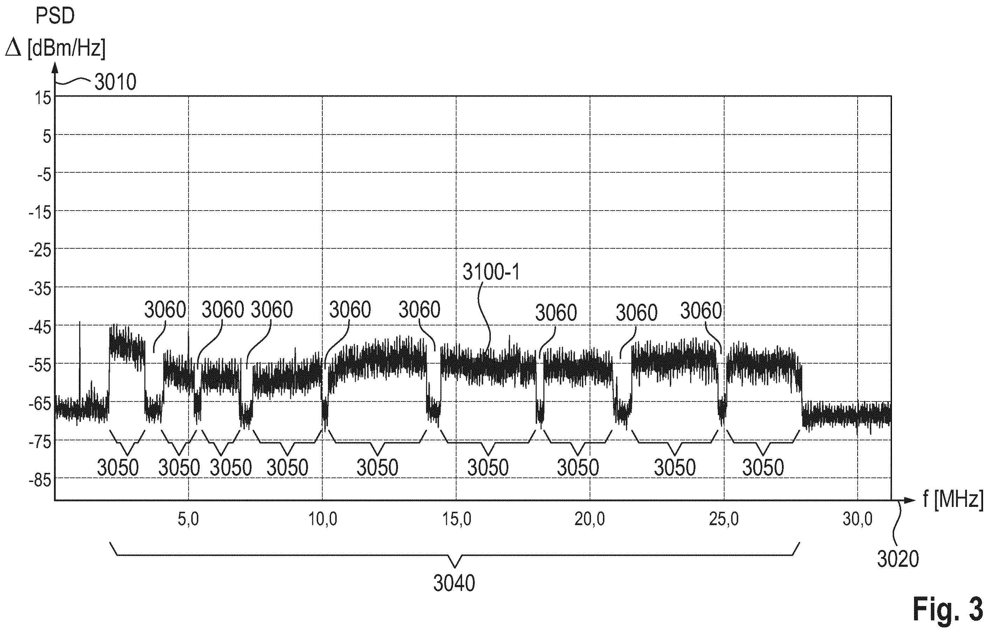

Wenn keine Störungen aufgrund einer nicht korrekten Impedanzanpassung der Endstufe 545 auftreten, weist das spektrale Leistungsdichtespektrum 3100-1 über einen Frequenzbereich 3040, der für die Hochfrequenzkommunikation genutzt wird, einen nahezu einheitlich konstanten Wert auf. Ein solches Leistungsdichtespektrum ist in Fig. 3 schematisch dargestellt. Aufgetragen ist die spektrale Leistungsdichte 3010 in dBm/Hz gegen die Frequenz 3020. Über die für die Powerline-Kommunikation genutzten Frequenzbereiche 3050 ist die spektrale Leistungsdichte (PSD) konstant. Die erkennbaren Lücken 3060 sind im Frequenzbereich ausgespart, da diese für andere Kommunikation, die nicht auf dem Kabel ausgeführt wird, reserviert sind. Für eine Powerline-Kommunikation der o.g. Art, bei der 250 nW Hochfrequenzleistung je verwendetem Träger genutzt werden, ergibt sich beispielsweise bei einer Bestimmung des Leistungsdichtespektrums bezogen eine Auflösungsbandbreite (RBW) von 10 Kilohertz (kHz) ein Wert von etwa -35 dBm RBW 10 kHz.

Die Prüfvorrichtung 100 umfasst eine Auswerteeinrichtung 200, in der das so ermittelte spektrale Leistungsdichtespektrum ausgewertet wird. Als korrekt hinsichtlich der Impedanz angepasst wird die zu prüfende Endstufe 545 angesehen, wenn das spektrale Leistungsdichtespektrum dem erwarteten spektrale Leistungsdichtespektrum entspricht. Hierfür kann dieses beispielsweise mit einem spektralen Leistungsdichtespektrum verglichen werden, welches in einem Speicher 210 der Auswerteeinrichtung 200 abgelegt ist. Alternativ oder zusätzlich können Überhöhungen und/oder Absenkungen/Einbrüche in dem spektrale Leistungsdichtespektrum ermittelt werden.

Treten Überhöhungen oder Einbrüche in dem Spektrum der spektralen Leistungsdichte auf, so ist dies ein Indiz dafür, dass die Endstufe 545, die geprüft wird, nicht korrekt hinsichtlich der Impedanz abgestimmt ist. Ein Ergebnis der Auswertung wird über eine Ausgabeeinrichtung 280 ausgegeben.

Die Ausgabeeinrichtung 280 kann eine Anzeige in digitaler oder analoger Form sein. Alternativ kann auch eine akustische Ausgabe erfolgen. Diese kann zusätzlich zu einer grafischen oder visuellen Ausgabe vorgesehen sein. Die Ausgabeeinrichtung kann auch eine Schnittstelle sein, um das Ergebnis der Auswertung einer anderen Vorrichtung zu übermitteln. Hierbei kommen alle beliebigen bekannten Schnittstellen, sowohl drahtgebundene als auch Funkschnittstellen, in Betracht.

Um auszuschließen, dass die Auswertung von einer konkreten Kabellänge des Ladekabels 310 abhängig ist, wird bei einer bevorzugten Weiterbildung das Kabel 310 mit einer Länge durch ein anderes Kabel 320 mit einer anderen Länge, die von der einen Länge verschieden ist, ersetzt. Erneut wird ein Hochfrequenzsignal von der Hochfrequenzsende- und Empfangseinheit 540 zu der zu prüfenden Endstufe 545 übertragen und währenddessen eine Abtastung durch die Abtasteinrichtung 150 vorgenommen und ein weiterer Zeittransient erfasst. Mittels der Berechnungseinheit 170 wird ein weiteres spektrales Leistungsdichtespektrum ermittelt.

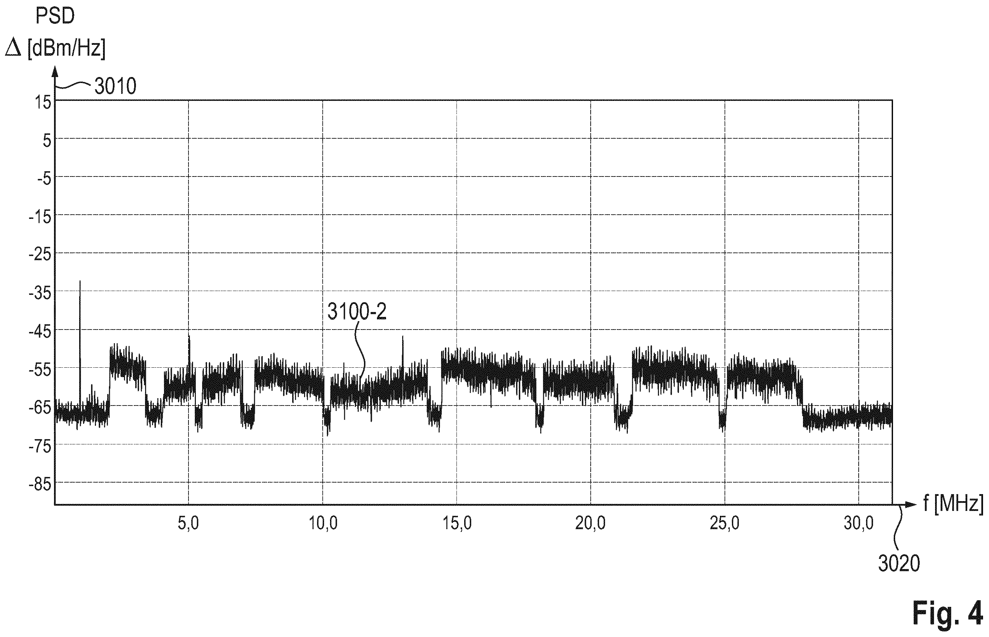

Fig. 4 zeigt ein spektrales Leistungsdichtespektrum 3100-2, das ebenfalls von einer korrekt abgestimmten Endstufe 545, über ein doppelt so langes Kabel 320 der Kabel 300 übertragen ist, welches ebenfalls in der Prüfvorrichtung über den ohmschen Abschlusswiderstand abgeschlossen ist.

Auch dieses spektrale Leistungsdichtespektrum 3100-2 zeigt keine ausgeprägten Überhöhungen oder Einbrüche der spektralen Leistungsdichte 3010.

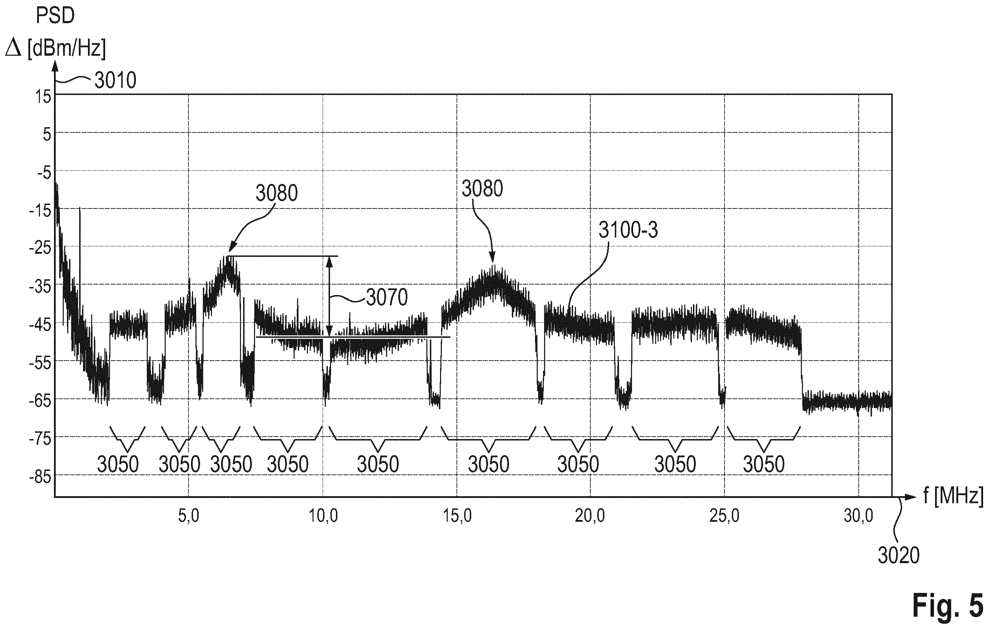

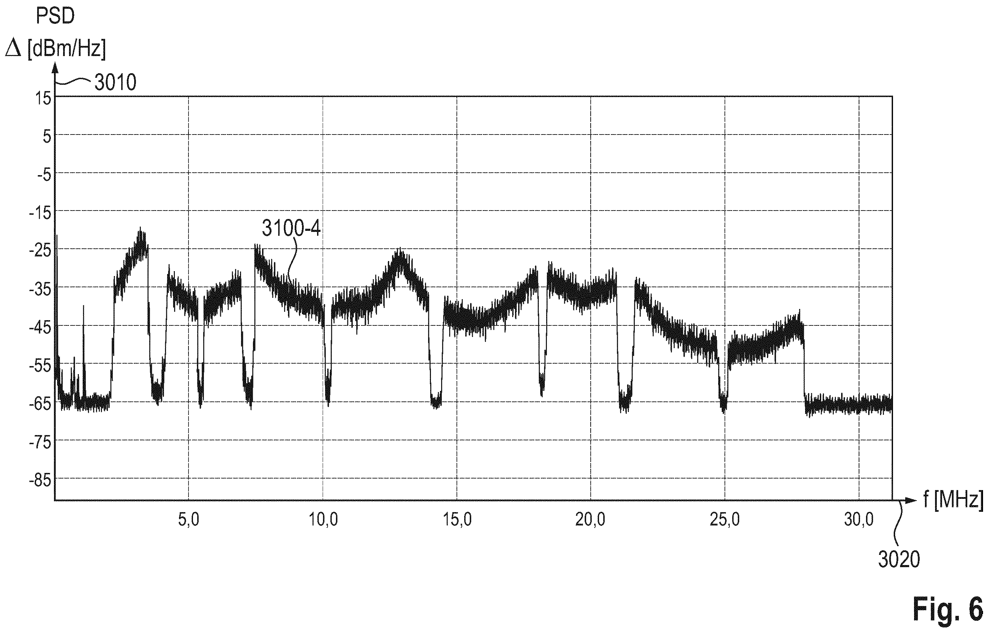

Im Gegensatz dazu zeigen die spektralen Leistungsdichtespektren 3100-3 der Fig 5 und 3100-4 der Fig. 6 deutliche Schwankungen 3070 der spektralen Leistungsdichte 3010 in den für die Kommunikation verwendeten Frequenzbereichen 3050. Das spektrale Leistungsdichtespektrum 3100-3 der Fig. 5 korrespondiert mit dem spektralen Leistungsdichtespektrum 3100-1 der Fig. 3. Das spektrale Leistungsdichtespektrum 3100-4 der Fig. 6 korrespondiert mit dem spektralen Leistungsdichtespektrum 3100-2 der Fig. 4. Alle diese spektralen Leistungsdichtespektren 3100-1 bis 3100-4 sind mit korrekt einer abgestimmten Endstufe 545 erzeugt.

Im Unterscheid zu den spektralen Leistungsdichtespektren 3100-1 und 3100-2, die jeweils mit einem korrekt an die Impedanz des jeweiligen Kabels 310, deren Längen sich jedoch unterscheiden, angepassten Abschlusswiderstand abgeschlossen Kabel 310 erfasst sind, sind die spektralen Leistungsdichtespektren 3100-3 und 3100-4 mit einem "offenen Ende" des aufgenommen.

Hierfür umfasst die Kabelabschlusseinrichtung 130 eine Umschalteinrichtung 140. Diese kann die Leitung wahlweise mit dem ohmschen Abschlusswiderstand 145 oder einem offenen Leitungsende 146 verbinden. Alternativ kann die Umschalteinrichtung 140 in einen geöffneten Zustand überführt werden, um die Leitung 120 zu öffnen.

In Fig. 5 und 6 sind Überhöhungen 3080 aufgrund von Reflexionen und insgesamt stake Schwankungen 3070 der spektralen Leistungsdichte erkennbar.

Es zeigt sich jedoch, dass die mit denselben Kabelabschlüssen erfassten spektralen Leistungsdichtespektren 3100-1, 3100-2 und 3011-3, 3100-4 paarweise jeweils denselben Mittelwert der spektralen Leistungsdichte aufweisen Die spektralen Leistungsdichtespektren 3100-1, 3100-2 weisen beispielsweise einen Mittelwert von -52 dBm und die spektralen Leistungsdichtespektren 3100-3, 3100-4 einen Mittelwert von -43 dBm auf.

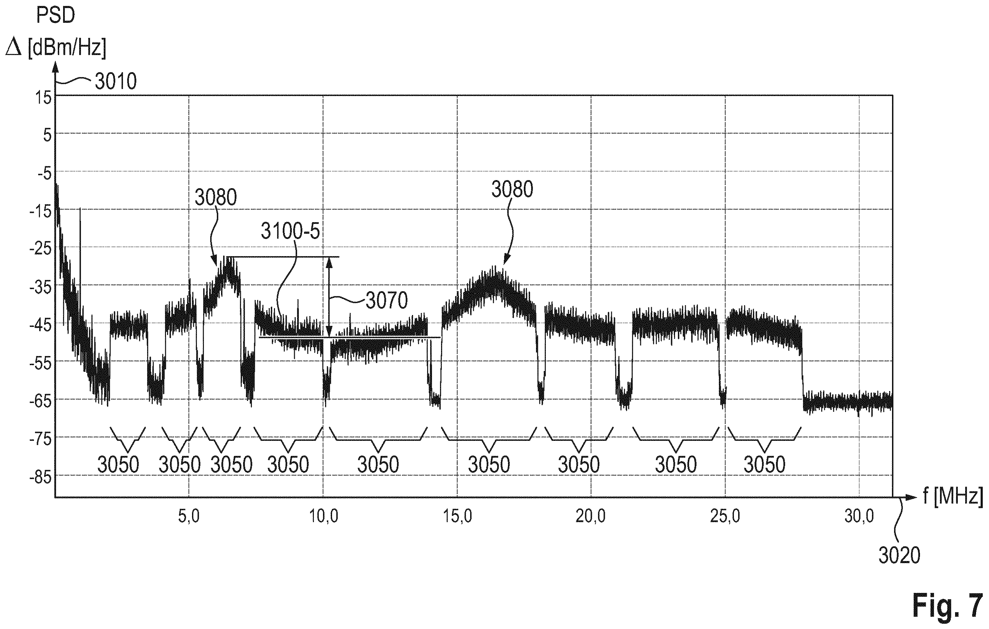

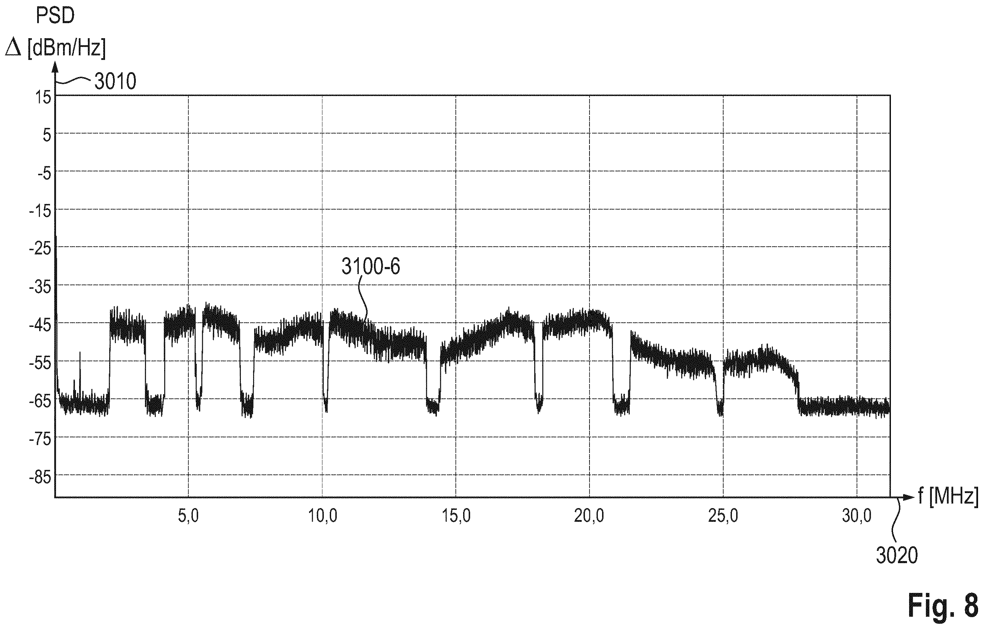

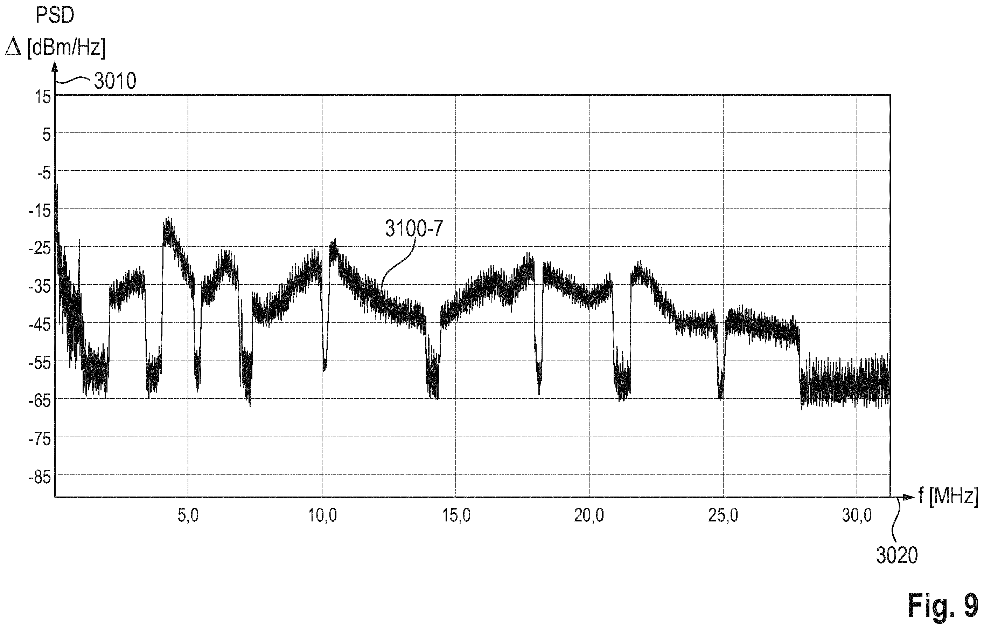

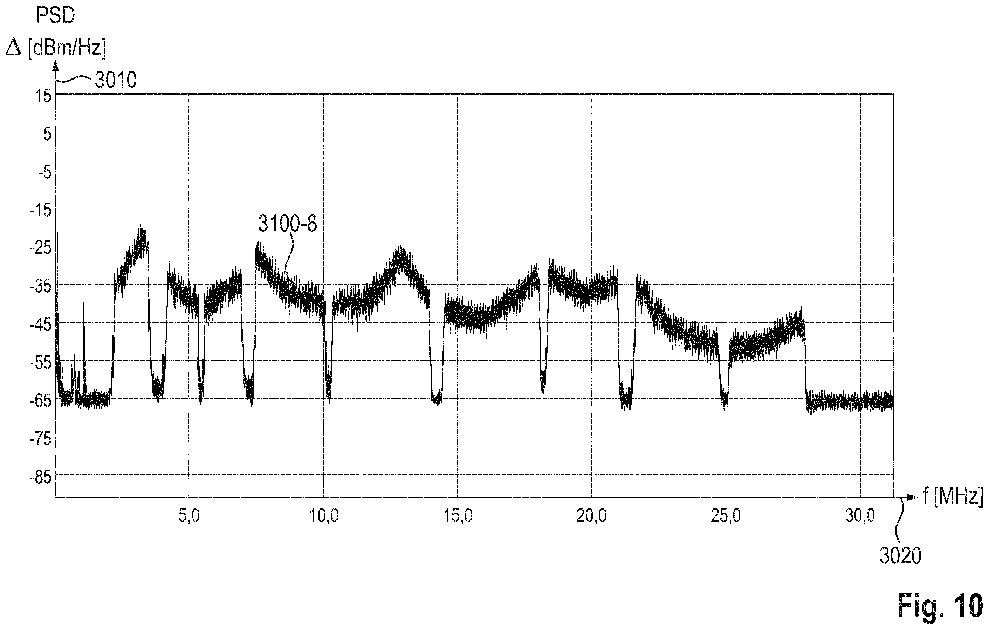

Fig. 7 bis 10 weisen die vergleichbaren spektralen Leistungsdichtespektren 3100-5 bis 3100-8 auf, die sich bei einer nicht korrekt hinsichtlich der Impedanz angepassten zu prüfenden Endstufe 545 ergeben.

Zu erkennen ist, dass in den spektralen Leistungsdichtespektren 3100-5 und 3100-6, die mit einem ohmschen Abschlusswiderstand 145 in der Prüfvorrichtung 100 erfasst sind, deutliche Schwankungen 3070 der spektralen Leistungsdichte 3010 auftreten. Zu erkennen sind auch Überhöhungen aufgrund von Reflexionen 3080. Der Mittelwert des spektralen Leistungsdichtespektrums 3100-5 von beispielsweise -43dBm unterscheidet sich von dem Mittelwert des spektralen Leistungsdichtespektrums 3100-6, das mit doppelter Kabellänge erfasst ist, von beispielsweise -46dBm, um 3dBm.

Auch die beiden analogen spektralen Leistungsdichtespektren 3100-7 und 3100-8, die jeweils mit·einem offenen Kabel 310, d.h. der geöffneten Leitung 120 in der Prüfvorrichtung 100, erfasst sind, zeigen wie erwartet starke Schwankungen 3070, aber auch denselben Unterschied von 3 dBm zwischen den Mittelwerten -37 dBm und - 40 dBm.

Anhand dieser Differenz kann auf die Abweichung der Impedanz der zu prüfenden Endstufe 545 geschlossen werden. Die Impedanz der Endstufe 545 ergibt sich als Produkt aus der Differenz, angegeben in dBm/Hz, umgerechnet in einen Faktor, multipliziert mit der Impedanz des verwendeten Ladekabels. Die Umrechnung des Dezibelwertes in eine Faktor F erfolgt, wie es bei der Umrechnung Energie oder Leistungsgrößen üblich ist: $F = {10}^{\frac{D}{10}}$, wobei D die Differenz in dBm/Hz ist und 0 dBm/Hz mit dem Faktor 1 assoziert ist.

Die Abweichungen von 3dBm entspricht etwa einem Faktor 2. Somit kann abgeschätzt werden: Z_{E}= 2·Z_{A}, wobei Z_{A} = 100 Ohm. Die nicht korrekt abgestimmte zu prüfende Endstufe weist somit eine abgeschätzte Impedanz von etwa 200 Ohm auf, Z_{E}= 2·100 Ohm = 200 Ohm.

Zusätzlich kann über die Umschalteinrichtung 140 der Kabelabschlusseinrichtung 130 die Leitung 120 auch mit einer anderen hinsichtlich der Impedanz korrekt abgestimmten Endstufe 45 einer weiteren Powerline-Kommunikationseinrichtung 40 verbunden werden. Dieser Abschluss des Kabels 310 stellt somit eine dritte Abschlussmöglichkeit dar. Auch mit diesem Abschluss können entsprechend spektrale Leistungsdichtespektren erfasst werden. Hierbei ist es jedoch notwendig, die andere Endstufe 45 so zu betreiben, dass diese selbst kein Hochfrequenzsignal während der Abtastung des Hochfrequenzsignals der zu prüfenden Endstufe 545 aussendet und entsprechend bedämpft ist.

Die weitere Powerline-Kommunikationseinrichtung 30 ist Bestandteil einer weiteren Kommunikationseinrichtung 20 die beispielsweise in einem Elektrofahrzeug 10 angeordnet ist.

Das Abschließen der Leitung 120 und des Kabels 310 über die andere korrekt abgestimmte Endstufe 45 kann von Vorteil sein, um eine Aussendung des Hochfrequenzsignals der zu prüfenden Endstufe 454 zu initiieren. In der Regel werden Aussendungen genutzt, die zu Beginn einer Übertragung gemäß einem Übertragungsprotokoll vorgenommen werden. Hierbei wird, häufig iterativ, eine breitbandiges Hochfrequenzsignal ausgesendet, dessen spektrale Leistungsdichte über den gesamten genutzten Frequenzbereich, d.h. oftmals mehrere beabstandete Frequenzbereiche konstant ist.

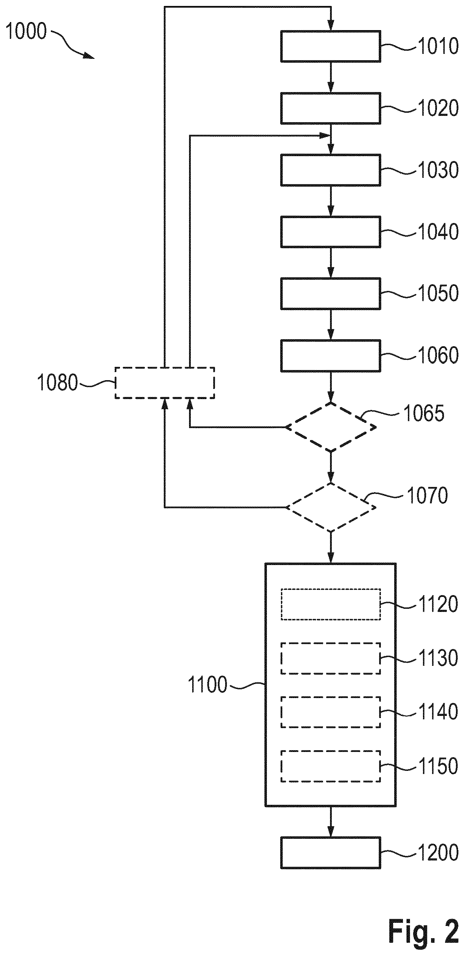

In Fig. 2 ist das Verfahren 1000 zum Prüfen einer Endstufe hinsichtlich einer Impedanzanpassung noch einmal schematisch dargestellt. Zunächst wird eines der Kabel, die vorzugsweise Ladekabel sind, ausgewählt 1010. Hierbei wird eine Kabel mit einer Länge ausgewählt. Anschließend wird die zu prüfende Endstufe mit der Vorrichtung zum Prüfen der Endstufe verbunden 1020. In oder an einer Prüfeinrichtung wird eine Abschlussimpedanz für das Kabel festgelegt 1030. Vorzugsweise zunächst auf einen Wert, der dem Leitungswiderstand des Kabels entspricht. Ein mittels der Hochfrequenzsende- und Empfangseinheit der Powerline-Kommunikationseinrichtung erzeugtes und mittels der zu prüfenden Endstufe auf das Ladekabel eingekoppeltes breitbandiges Hochfrequenzsignal wird während der Übertragung über das Ladekabel abgetastet 1040. Dieses erfolgt in Übereinstimmung mit dem Nyquist-Shannon-Abtasttheorem. Hierbei wird ein Zeittransient erfasst 1050.

Aus dem Zeittransienten, der für das eine Kabel mit der einen Länge erfasst ist, wird ein spektrales Leistungsdichtespektrum (PSD-Spektrum) ermittelt 1060.

In der einfachsten Ausführungsform wird eine Auswertung vorgenommen 1100. Hierbei wird das aus dem Zeittransienten ermittelte spektrale Leistungsdichtespektrum zumindest in einem Frequenzbereich, vorzugsweise in mehreren Frequenzbereichen auf Abweichungen von einem erwarteten spektralen Leistungsdichtespektrum untersucht 1120. Werden beispielsweise Überhöhungen oder Einbrüche in einem bestimmten Frequenzbereich festgestellt, wird die zu prüfende Endstufe als nicht korrekt abgestimmt eingestuft. Entspricht das spektrale Leistungsdichtespektrum hingegen in dem oder den mehreren untersuchten Frequenzbereichen den Erwartungen, so wird die Endstufe als korrekt hinsichtlich der Impedanz abgestimmt eingestuft. Das Ergebnis wird ausgegeben 1200.

Bei einer verbesserten Ausführungsform wird nach dem Erfassen des Zeittransienten und ermitteln des spektralen Leistungsdichtespektrums für das eine Ladekabel mit der einen Länge geprüft, ob ein anderes Ladekabel mit einer anderen Länge vorliegt 1070. Ist dies der Fall, wird das bereits ermittelte spektrale Leistungsdichtespektrum für die spätere Auswertung gespeichert 1080. Anschließend wird beim erneuten Auswählen eines der Kabel 1010 ein anderes der Ladekabel mit einer anderen Länge ausgewählt. Anschließend werden die Verfahrensschritte des Verbindens der zu prüfenden Endstufe mit der Vorrichtung zum Prüfen mit dem anderen Ladekabel 1020, das Festlegen des Kabelabschlusses 1030, das Abtasten des Hochfrequenzsignals 1040 und das Erfassen des Zeittransienten 1050 für das andere Ladekabel mit der anderen Länge erneut ausgeführt. Hierbei wird die der Kabelabschluss identisch wie bei dem ersten Kabel festgelegt. Anschließend wird für den zweiten jetzt erfassten Zeittransienten das zugehörige spektrale Leistungsdichtespektrum errechnet 1060. Anschließend wird beim Auswerten auch für dieses spektralen Leistungsdichtespektrum geprüft, ob es Überhöhungen oder Einbrüche gibt. Zusätzlich oder alternativ wird für beide ermittelten spektralen Leistungsdichtespektren jeweils ein Mittelwert bestimmt 1130. Diese werden verglichen 1140. Sind diese gleich, so ist davon auszugehen , dass die zu prüfenden Endstufe korrekt abgestimmt ist.

Noch weiter kann die Auswertung verbessert werden, indem die Verfahrensschritte 1010 bis 1080 jeweils für mehrere Kabellängen, insbesondere zwei Kabellängen und auch für mehre verschiedene Kabelabschlüsse in der Prüfeinrichtung ausgeführt sind. Dieses wird bei einer Ausführungsform im Verfahrensschritt 1065 geprüft. Hier wird geprüft , ob für das bisher vermessene Kabel, bereits mindestens zwei verschiedene, vorzugsweise drei verschiedene Kabelabschlüsse hinsichtlich der Impedanz zur Ermittlung eines spektralen Leistungsdichtespektrums genutzt wurden. Ist dieses nicht der Fall, so werden die Verfahrensschritte Abspeichern des zuletzt ermittelten Leistungsdichtespektrums 1080, Festlegen der Abschlussimpedanz 1030, Abtasten des Hochfrequenzsignals 1040 der zu prüfenden Endstufe und erfassen eines Zeittransienten 1050 sowie bestimmten des spektralen Leistungsdichtespektrums 1060 iteriert. Auswerteschritte 11xx können zum Teil auch nach dem Erfassen einzelner oder mehrerer der spektralen Leistungsdichtespektren vorgenommen werden oder am Ende des Verfahrens.

Bei der einen beschrieben Variante des Verfahrens werden für jedes Kabel, sofern mehrere Kabellängen und Kabelabschlüsse genutzt werden, erst die Spektren für die verschiedenen Kabelabschlüsse erfasst und ermittelt und dann das Kabel gewechselt. Es geht jedoch auch in anderer Reihenfolge.

Werden bei der Mittelwertauswertung für unterschiedliche Kabellängen, aber denselben Kabelabschluss Differenzen erkannt, kann die Impedanz der zu prüfenden Endstufe abgeschätzt werden 1150. Bevorzugt wird diese Auswertung plausibilisiert, in dem geprüft wird, ob für zwei verschiedene Kabelabschlüsse, bei Verwendung von unterschiedlichen Kabeln, die Mittelwertdifferenzen jeweils für Kabelpaare bei den unterschiedlichen Kabelabschlüssen im Rahmen einer vorgegebenen Toleranz gleich sind. Ist dieses der Fall, ist die Abschätzung der Impedanz der zu prüfenden Endstufe als zuverlässig einzustufen.

Bei manchen Ausführungsformen wird die geschätzte Impedanz nur bestimmt oder nur ausgegeben, wenn die Mittelwertdifferenzen für mindestens ein Kabelpaar mit Kabeln unterschiedlicher Länge für zwei unterschiedliche Kabelabschlüsse, d.h. Abschlussimpedanzen im oder an der Prüfvorrichtung einander im Rahmen der vorgegebenen Toleranz gleichen. Vorzugsweise ist eine Abschlussimpedanz als unendlich gewählt, die durch eine offene Leitung 146 hergestellt wird. Die andere Impedanz wird vorzugweise als angepasst an die Kabelimpedanz gewählt und durch das Abschließen über einen ohmschen Abschlusswiderstand realisiert. Alternativ kann eine abgestimmte Endstufe einer Powerline-Kommunikationseinrichtung genutzt werden.

Die Berechnungseinheit und die Auswerteeinrichtung sind vorzugsweise mittels einer programmgesteuerten Recheneinheit ausgeführt. Alternativ können auch elektronische Schaltungen genutzt werden, die insbesondere die Berechnung des spektralen Leistungsdichtespektrums vornehmen.

Es versteht sich für den Fachmann, dass hier lediglich beispielhafte Ausführungsformen beschrieben sind. Die Merkmale der unterschiedlichen Ausführungsformen können in beliebiger Kombination miteinander verwendet werden, um andere Ausführungsformen zu bilden.

### Bezugszeichenliste

- 10: Elektrofahrzeug
- 20: Kommunikationseinrichtung
- 30: Powerline-Kommunikationseinrichtung
- 40: Hochfrequenzsende- und Empfangseinheit
- 45: Endstufe
- 100: Prüfvorrichtung zum Prüfen einer Endstufe
- 110: Kabelabschluss
- 120: Leitung
- 130: Kabelabschlusseinrichtung
- 140: Umschalteinrichtung
- 145: ohmscher Abschlusswiderstand
- 146: offene Leitung
- 150: Abtasteinrichtung
- 170: Berechnungseinheit
- 200: Auswerteeinrichtung
- 210: Speicher
- 220: Vergleichseinrichtung
- 280: Ausgabeeinrichtung
- 300: Kabel
- 305: Zweidrahtleitung
- 310: ein Kabel einer Länge
- 320: anderes Kabel anderer Länge
- 500: Ladesäule
- 520: Kommunikationseinrichtung
- 530: Powerline-Kommunikationseinrichtung
- 540: Hochfrequenzsende- und Empfangseinheit
- 545: Endstufe
- 1000: Verfahren zum Prüfen von Endstufen
- 1010: Auswählen eines der Kabel oder eines anderen der Kabel mit anderer Länge
- 1020: Verbinden der Endstufe mit der Vorrichtung zum Prüfen
- 1030: Festlegen der Abschlussimpedanz
- 1040: Abtasten des übertragenen Hochfrequenzsignals
- 1050: Erfassen eines Zeittransienten
- 1060: Ermitteln eines spektralen Leistungsdichtespektrums
- 1065: Ist das aktuell verbundene Kabel mit verschiedenen Impedanzabschlüssen verwendet worden?
- 1070: Prüfen, ob Kabel mit anderer Länge vorliegen
- 1080: Speichern des ermittelten spektralen Leistungsdichtespektrum
- 1100: Auswerten des/der spektralen Leistungsdichtespektren
- 1120: Prüfen auf Abweichungen von einem erwarteten/korrekten spektralen Leistungsdichtespektrum
- 1130: Mittelwert der spektralen Leistungsdichtespektren bestimmen
- 1140: Mittelwerte vergleichen /Differenzen bilden
- 1150: Errechnen der geschätzten Impedanz der zu prüfenden Endstufe
- 1200: Ausgeben des Ergebnisses/der Ergebnisse der Auswertung
- 3010: spektrale Leistungsdichte
- 3020: Frequenz
- 3040: Frequenzbereich
- 3050: genutzte Frequenzbereiche
- 3060: Lücken
- 3070: Schwankungen
- 3100, 3100-x: spektrales Leistungsdichtespektrum ,-x Zählindex

## Patentansprüche

1. Verfahren zum Prüfen von Endstufen (545), insbesondere von Elektrofahrzeugen oder Ladestationen, für eine breitbandige hochfrequente Powerline-Kommunikation über Kabel (300, 310, 320), umfassend die Schritte:
a) Verbinden der zu prüfenden Endstufe (545) und einer Prüfeinrichtung mit einem der Kabel (310),
b) Festlegen einer Abschlussimpedanz des Kabels an oder in der Prüfvorrichtung
c) Abtasten eines auf dem einen der Kabel (310) von der zu prüfenden Endstufe übertragenen breitbandigen Hochfrequenzsignals, das in jedem für die Hochfrequenzkommunikation genutzten Frequenzbereich (3050) des breitbandigen Hochfrequenzsignals mit einer konstanten spektralen Leistungsdichte erzeugt wird, gemäß dem Nyquist-Shannon-Abtasttheorem an dem der Prüfvorrichtung (100) zugeordneten Ende des einen der Kabel (310) und Erfassen mindestens eines Zeittransienten, beides während des Übertragens des breitbandigen Hochfrequenzsignals,
d) Ermitteln eines dem einen der Kabel (310) und der festgelegten Abschlussimpedanz zugeordneten spektralen Leistungsdichtespektrums (3100) anhand des mindestens einen unter Verwendung des einen der Kabel (310) für die festgelegte Abschlussimpedanz erfassten Zeittransienten
e) Auswerten des einen oder der mehreren für die Kommunikation genutzten Frequenzbereiche (3050) des spektralen Leistungsdichtespektrums,
f) wobei im Schritt b) die Abschlussimpedanz auf einen Wert festgelegt wird, der an eine Impedanz der Kabel (300) angepasst ist und im Schritt e) beim Auswerten geprüft wird, ob Abweichungen in einem oder mehreren Bereichen des spektrales Leistungsdichtespektrums gegenüber einem spektralen Leistungsdichtespektrum auftreten, das bei einer Kommunikation mit einer korrekt hinsichtlich der Impedanz angepassten Endstufe erwartet wird oder erfasst ist, und
g) Ausgeben eines Ergebnisses der Auswertung, das zumindest eine Angabe über eine Korrektheit der Impedanzanpassung oder Unkorrektheit der Impedanzanpassung der zu prüfenden Endstufe (545) umfasst.

2. Verfahren nach Anspruch 1, **dadurch gekennzeichnet, dass** das Prüfen im Verfahrensschritt e), ob Abweichungen dem in einem oder mehreren Bereichen (3050) des spektrales Leistungsdichtespektrums (3100-x) gegenüber einem spektralen Leistungsdichtespektrum auftreten, das bei einer Kommunikation mit einem korrekt hinsichtlich der Impedanz angepassten Endstufe erwartet wird oder erfasst ist, umfasst, dass geprüft wird, ob in einem für eine an die Impedanz des Kabels angepasste Abschlussimpedanz ermittelten spektralen Leistungsdichtespektrum Schwankungen der spektralen Leistungsdichte oberhalb eines Schwellenwertes auftreten.

3. Verfahren nach Anspruch 1 oder 2, **dadurch gekennzeichnet, dass** die Schritte a) bis d) zusätzlich unter Verwendung mindestens ein anderes der Kabels (320) ausgeführt werden, wobei das mindestens eine andere der Kabel (320) eine von dem mindestens einen der Kabel (310) abweichende Länge aufweist, und die Abschlussimpedanz im Schritt b) identisch festgelegt wird, wie beim Ausführen der Schritte a) bis d) für das mindestens eine der Kabel und dass das Auswerten des Schritts e) umfasst, dass für die ermittelten spektralen Leistungsdichtespektren jeweils eine mittlere spektrale Leistungsdichte über die für die Powerline-Kommunikation genutzten Frequenzbereiche (3050) berechnet wird, die Mittelwerte paarweise für spektrale Leistungsdichtespektren (3100-x) verglichen werden, die für unterschiedliche Kabellängen, aber dieselbe Abschlussimpedanz erfasst sind, und die zu prüfende Endstufe als nicht korrekt abgestimmt eingestuft wird, wenn hierbei Abweichungen oberhalb eine Mittelwertschwellenwertes auftreten.

4. Verfahren nach Anspruch 3, **dadurch gekennzeichnet, dass** die Verfahrensschritte a) bis d) für mehrere der Kabel mit einer unterschiedlichen Länge ausgeführt werden, wobei die Schritte a) bis d) für jedes der mehreren Kabel (300) mindestens zwei Mal durch geführt werden, wobei im Verfahrensschritt b) unterschiedlich Abschlussimpedanzen festgelegt werden, und beim Auswerten im Verfahrensschritt e) die Differenzen der mittleren spektralen Leistungsdichten der für verschiedene Kabellängen, aber identische Abschlussimpedanzen ermittelten spektralen Leistungsdichtespektren für mindestens zwei der unterschiedlich festgelegten Abschlussimpedanzen verglichen werden, und wenn diese Differenzen der Mittelwerte im Rahmen einer Toleranz gleich, aber von Null verschieden sind, anhand der Differenz die Abschlussimpedanz der zu prüfenden Endstufe abgeschätzt wird, indem die Differenz in einen Faktor umgerechnet wird und mit der Impedanz der Kabel multipliziert wird.

5. Verfahren nach einem der vorangehenden Ansprüche, **dadurch gekennzeichnet, dass** das Festlegen der Abschlussimpedanz auf einen Wert, der an eine Impedanz der Kabel angepasst ist, erfolgt, indem eine mit dem entsprechenden der Kabel verbundenen Leitung in oder an der Prüfvorrichtung über einen ohmschen Abschlusswiderstand abgeschlossen wird, dessen Impedanz einer Leitungsimpedanz der Kabel entspricht, oder indem das entsprechende der Kabel in oder an der Prüfvorrichtung mit Endstufenschaltung einer Hochfrequenzsende- und Empfangseinheit (40) verbunden wird, die hinsichtlich der Impedanz über den gesamten für die Powerline-Kommunikation genutzten Frequenzbereich korrekt abgestimmt ist und hinsichtlich einer eignen Aussendung während des Empfangs des Hochleistungssignals der zu prüfenden Endstufe (545) bedämpft ist.

6. Verfahren nach einem der vorangehenden Ansprüche, **dadurch gekennzeichnet, dass** die im Verfahrensschritt b) festgelegten unterschiedlichen Impedanzen eine unendliche Impedanz umfassen, die festgelegt wird, indem die mit dem entsprechenden der Kabel (300) verbundene Leitung (120) in oder an der Prüfvorrichtung geöffnet wird.

7. Verfahren nach einem der vorangehenden Ansprüche, **dadurch gekennzeichnet, dass** die Kabel (300) mit Zweidrahtleitungen (305) für die Powerline-Kommunikation bereitgestellt werden und dass die Impedanz der Kabel (300) jeweils 100 Ohm beträgt.

8. Verfahren nach einem der vorangehenden Ansprüche, **dadurch gekennzeichnet, dass** zu der zu prüfenden Endstufen (545) für eine breitbandige hochfrequente Powerline-Kommunikation ein Signal übertragen wird, um die Aussendung des breitbandigen Hochfrequenzsignals auszulösen, das in jedem für die Hochfrequenzkommunikation genutzten Frequenzbereich des breitbandigen Hochfrequenzsignals mit einer konstanten spektralen Leistungsdichte erzeugt wird.

9. Prüfvorrichtung (100) zum Prüfen von Endstufen (545), insbesondere von Elektrofahrzeugen oder Ladestationen (500), für eine breitbandige hochfrequente Powerline-Kommunikation über Kabel (300), umfassend:
einen Kabelanschluss (110) zum Anschließen eines Endes eines der Kabel (310), das mit einem anderen Ende mit der zu prüfenden Endstufe (545) verbunden ist ;
eine mit dem Kabelanschluss (110) verbundene Kabelabschlusseinrichtung (120), zum Festlegen eines Abschlusswiderstands der mit dem Kabelanschluss (110) verbunden Leitung (120) an oder in der Prüfvorrichtung;
eine mit dem Kabelanschluss (110) verbundene Abtasteinrichtung (150) zum Abtasten des auf dem einen der Kabel (310) übertragenen breitbandigen Hochfrequenzsignals gemäß dem Nyquist-Shannon-Abtasttheorem und Erfassen mindestens eines Zeittransienten, beides während des Übertragens des breitbandigen Hochfrequenzsignals;
eine Berechnungseinheit (170) zum Ermitteln eines dem einen der Kabel (310) zugeordneten spektralen Leistungsdichtespektrums anhand des mindestens einen unter Verwendung des einen der Kabel (310) erfassten Zeittransienten, und
eine Auswerteeinrichtung (200) zum Auswerten eines oder mehrerer Frequenzbereiche (3050) des spektralen Leistungsdichtespektrums (3100-x),
wobei beim Auswerten geprüft wird, ob Abweichungen in einem oder mehreren Frequenzbereichen (3050) des spektralen Leistungsdichtespektrums (3100-x) gegenüber einem spektralen Leistungsdichtespektrum auftreten, das bei einer Kommunikation mit einem korrekt hinsichtlich der Impedanz angepassten Endstufe erwartet wird oder erfasst ist, und
eine Ausgabeeinrichtung (280), welche ein Ergebnis der Auswertung ausgibt, welche zumindest eine Angabe über eine Korrektheit oder Unkorrektheit der Impedanzanpassung der zu prüfenden Endstufe (545) ausgibt.

10. Prüfvorrichtung (100) nach Anspruch 9, **dadurch gekennzeichnet, dass** die Kabelabschlusseinrichtung (130) einen ohmschen Abschlusswiderstand (145) umfasst, der der Impedanz der Kabel entspricht.

11. Prüfvorrichtung (100) nach Anspruch 10, **dadurch gekennzeichnet, dass** die Kabelabschlusseinrichtung eine Umschalteinrichtung umfasst, um die Leitung in oder an der Vorrichtung zum Prüfen, über den Abschlusswiderstand, der der Impedanz der Kabel (300) entspricht, abzuschließen, oder in einen offenen Zustand zu schalten, um eine unendliche Impedanz zu simulieren, oder mit einer korrekt hinsichtlich der Impedanz angepassten Endstufe einer Hochfrequenzsende- und Empfangseinheit (40) einer Powerline-Kommunikationseinrichtung (30) zu verbinden, um eine optimale Anpassung des Kabelabschlusses herzustellen.

12. Prüfvorrichtung (100) nach einem der Ansprüche 9 bis 11, **dadurch gekennzeichnet, dass** die Prüfvorrichtung Bestandteil einer Powerline-Kommunikationseinrichtung (30) ist.

13. Prüfvorrichtung (100) nach einem der Ansprüche 9 bis 12, **dadurch gekennzeichnet, dass** diese ausgebildet ist, das Verfahren gemäß den Ansprüchen 1 bis 8 auszuführen.

14. System (500) zum Prüfen von Endstufen (545), insbesondere von Elektrofahrzeugen oder Ladestationen (500), für eine breitbandige hochfrequente Powerline-Kommunikation hinsichtlich ihrer Impedanzanpassung, umfassend die Prüfvorrichtung (100) nach einem der Ansprüche 9 bis 13 und mindestens ein hinsichtlich der Impedanz an die Hochfrequenzsende- und Empfangseinheit (40) der Vorrichtung (100) angepasstes Kabel (300), vorzugsweise mehrere Kabel (300, 310, 320) unterschiedlicher Länge, für die Powerline-Kommunikation zum Verbinden mit einer der zu prüfenden Endstufen (545).

## Claims

1. Method for testing output stages (545), in particular of electric vehicles or charging stations, for a broadband high-frequency powerline communication via cables (300, 310, 320), comprising the steps of:
a) connecting the output stage (545) to be tested and a test device by means of one of the cables (310),
b) setting a terminating impedance of the cable at or in the test apparatus,
c) sampling, in accordance with the Nyquist-Shannon sampling theorem and at the end of the one of the cables (310) associated with the test apparatus (100), a broadband high-frequency signal transmitted on the one of the cables (310) from the output stage to be tested, which signal is generated at a constant power spectral density in each frequency range (3050) of the broadband high-frequency signal used for the high-frequency communication, and detecting at least one time transient, both during the transmission of the broadband high-frequency signal,
d) ascertaining a power spectral density spectrum (3100) assigned to the one of the cables (310) and to the set terminating impedance, on the basis of the at least one time transient detected using the one of the cables (310) for the set termination impedance,
e) evaluating the one or the plurality of frequency ranges (3050) of the power spectral density spectrum used for the communication,
f) wherein, in step b), the terminating impedance is set to a value which is adjusted to an impedance of the cables (300) and, in step e), it is tested during the evaluation whether deviations occur in one or more ranges of the power spectral density spectrum with respect to a power spectral density spectrum that is expected or is detected during a communication with an output stage which is correctly adjusted with regard to the impedance, and
g) issuing a result of the evaluation, which result comprises at least one indication about a correctness of the impedance adjustment or incorrectness of the impedance adjustment of the output stage (545) to be tested.

2. Method according to claim 1, **characterized in that** the testing, in method step e), as to whether deviations occur in the one or more ranges (3050) of the power spectral density spectrum (3100-x) with respect to a power spectral density spectrum that is expected or is detected during a communication with an output stage which is correctly adjusted with regard to the impedance comprises testing whether fluctuations in the power spectral density which are above a threshold value occur in a power spectral density spectrum ascertained for a terminating impedance adjusted to the impedance of the cable.

3. Method according to claim 1 or 2, **characterized in that** steps a) to d) are additionally carried out using at least one other of the cables (320), wherein the at least one other of the cables (320) has a length deviating from the at least one of the cables (310), and the terminating impedance is set identically in step b) as when carrying out steps a) to d) for the at least one of the cables, and **in that** the evaluation of step e) comprises that a mean power spectral density across the frequency ranges (3050) used for the power line communication is calculated for each of the ascertained power spectral density spectrums, the mean values are compared in pairs for power spectral density spectrums (3100-x) that are detected for different cable lengths but the same terminating impedance, and the output stage to be tested is classified as not correctly matched when deviations above a mean value threshold value occur.

4. Method according to claim 3, **characterized in that** the method steps a) to d) are carried out for a plurality of the cables having a different length, wherein steps a) to d) are carried out at least twice for each of the plurality of cables (300), wherein, in method step b), different terminating impedances are set, and, during the evaluation in method step e), the differences of the mean power spectral densities of the power spectral density spectrums ascertained for different cable lengths but identical terminating impedances are compared for at least two of the differently set terminating impedances, and when these differences of the mean values are equal within a tolerance but different from zero, the terminating impedance of the output stage to be tested is estimated on the basis of the difference by converting the difference into a factor and multiplying it by the impedance of the cables.

5. Method according to any of the preceding claims, **characterized in that** the setting of the terminating impedance at a value which is adjusted to an impedance of the cables is achieved by terminating a line connected to the corresponding cable of the cables in or at the test apparatus by means of an ohmic terminating resistor, the impedance of which corresponds to a line impedance of the cables, or by connecting the corresponding cable of the cables in or at the test apparatus to the output stage circuit of a high-frequency transmitting and receiving unit (40) which is correctly matched with regard to the impedance across the entire frequency range used for the power line communication and is attenuated with regard to an emission thereof during the reception of the high-power signal of the output stage (545) to be tested.

6. Method according to any of the preceding claims, **characterized in that** the different impedances set in method step b) comprise an infinite impedance which is set by opening the line (120) connected to the corresponding cable (300) of the cables in or at the test apparatus.

7. Method according to any of the preceding claims, **characterized in that** the cables (300) having two-wire lines (305) are provided for the powerline communication and **in that** the impedance of each of the cables (300) is 100 ohms.

8. Method according to any of the preceding claims, **characterized in that** a signal is transmitted to the output stages (545) to be tested for a broadband high-frequency power line communication in order to trigger the emission of the broadband high-frequency signal which is generated at a constant power spectral density in each frequency range of the broadband high-frequency signal used for the high-frequency communication.

9. Test apparatus (100) for testing output stages (545), in particular of electric vehicles or charging stations (500), for a broadband high-frequency powerline communication via cables (300), comprising:
a cable connection (110) for connecting one end of one of the cables (310) that is connected by one other end to the output stage (545) to be tested;
a cable terminating device (120) connected to the cable connection (110) in order to set a terminating resistor of the line (120) connected to the cable connection (110) at or in the test apparatus;
a sampling device (150) connected to the cable connection (110) for sampling, in accordance with the Nyquist-Shannon sampling theorem, the broadband high-frequency signal transmitted on one of the cables (310), and detecting at least one time transient, both during the transmission of the broadband high-frequency signal;
a calculation unit (170) for ascertaining a power spectral density spectrum assigned to the one of the cables (310), on the basis of the at least one time transient detected using the one of the cables (310), and
an evaluation device (200) for evaluating one or more frequency ranges (3050) of the power spectral density spectrum (3100-x), wherein, during the evaluation, it is checked whether deviations occur in one or more frequency ranges (3050) of the power spectral density spectrum (3100-x) with respect to a power spectral density spectrum that is expected or is detected during a communication with an output stage which is correctly adjusted with regard to the impedance, and
an issuing device (280) which issues a result of the evaluation and which issues at least one indication of a correctness or incorrectness of the impedance adjustment of the output stage (545) to be tested.

10. Test apparatus (100) according to claim 9, **characterized in that** the cable terminating device (130) comprises an ohmic terminating resistor (145) which corresponds to the impedance of the cables.

11. Test apparatus (100) according to claim 10, **characterized in that** the cable terminating device comprises a switching device to terminate the line in or at the apparatus for testing, by means of the terminating resistor which corresponds to the impedance of the cables (300), or to switch it into an open state in order to simulate an infinite impedance, or to connect it to an output stage of a high-frequency transmitting and receiving unit (40) of a power line communication device (30) that is correctly adjusted with regard to the impedance in order to produce an optimal adjustment of the cable termination.

12. Test apparatus (100) according to any of claims 9 to 11, **characterized in that** the test apparatus is part of a powerline communication device (30).

13. Test apparatus (100) according to any of claims 9 to 12, **characterized in that** it is designed to carry out the method according to claims 1 to 8.

14. System (500) for testing output stages (545), in particular of electric vehicles or charging stations (500), for a broadband high-frequency powerline communication with regard to the impedance adjustment of the output stages, comprising the test apparatus (100) according to any of claims 9 to 13 and at least one cable (300) adjusted with regard to the impedance to the high-frequency transmitting and receiving unit (40) of the apparatus (100), preferably a plurality of cables (300, 310, 320) of different lengths, for the powerline communication for connecting to one of the output stages (545) to be tested.

## Revendications

1. Procédé permettant de vérifier des étages de sortie (545), en particulier de véhicules électriques ou de stations de recharge, pour une communication à large bande et à haute fréquence par courants porteurs en ligne par l'intermédiaire de câbles (300, 310, 320), comprenant les étapes consistant à :
a) connecter l'étage de sortie (545) à vérifier et un appareil de vérification à l'un des câbles (310),
b) déterminer une impédance terminale du câble au niveau du dispositif de vérification ou dans celui-ci
c) échantillonner un signal haute fréquence à large bande transmis sur l'un des câbles (310) à partir de l'étage de sortie à vérifier, lequel signal est généré dans chaque bande de fréquences (3050) utilisée pour la communication haute fréquence du signal haute fréquence à large bande avec une densité spectrale de puissance constante, conformément au théorème d'échantillonnage de Nyquist-Shannon, à l'extrémité de l'un des câbles (310) associée au dispositif de vérification (100), et détecter au moins un transitoire temporel, ces deux étapes étant effectuées pendant la transmission du signal haute fréquence à large bande,
d) définition d'un spectre de densité spectrale de puissance (3100) associé à l'un des câbles (310) et à l'impédance terminale déterminée à partir de l'au moins un transitoire temporel détecté à l'aide de l'un des câbles (310) pour l'impédance terminale déterminée
e) analyser la ou les bandes de fréquences (3050) du spectre de densité spectrale de puissance utilisées pour la communication,
f) dans lequel, à l'étape b), l'impédance terminale est fixée à une valeur adaptée à l'impédance des câbles (300) et, à l'étape e), lors de l'évaluation, on vérifie si des écarts apparaissent dans une ou plusieurs bandes du spectre de densité spectrale de puissance par rapport à un spectre de densité spectrale de puissance attendu ou détecté lors d'une communication avec un étage de sortie correctement adapté en termes d'impédance, et
g) délivrer en sortie un résultat de l'analyse qui comprend au moins une indication précisant si l'adaptation d'impédance de l'étage de sortie (545) à vérifier est correcte ou incorrecte.

2. Procédé selon la revendication 1, **caractérisé en ce que** la vérification à l'étape de procédé e), consistant à vérifier si des écarts apparaissent dans une ou plusieurs bandes (3050) du spectre de densité spectrale de puissance (3100-x) par rapport à un spectre de densité spectrale de puissance attendu ou détecté lors d'une communication avec un étage de sortie correctement adapté en termes d'impédance, comprend le fait de vérifier si, dans un spectre de densité spectrale de puissance défini pour une impédance terminale adaptée à l'impédance du câble, des fluctuations de la densité spectrale de puissance supérieures à une valeur seuil apparaissent.

3. Procédé selon la revendication 1 ou 2, **caractérisé en ce que** les étapes a) à d) sont en outre exécutées à l'aide d'au moins un autre des câbles (320), dans lequel l'au moins un autre des câbles (320) présente une longueur différente de celle de l'au moins un des câbles (310), et l'impédance terminale est déterminée à l'étape b) de manière à être identique à celle utilisée lors de l'exécution des étapes a) à d) pour l'au moins un des câbles, **et en ce que** l'analyse de l'étape e) comprend le fait que, pour les spectres de densité spectrale de puissance définis, respectivement une densité spectrale de puissance moyenne sur les bandes de fréquences (3050) utilisées pour la communication par courants porteurs en ligne est calculée, les valeurs moyennes pour des spectres de densité spectrale de puissance (3100-x) détectés pour des longueurs de câbles différentes, mais avec la même impédance terminale, sont comparées par paires, et l'étage de sortie à vérifier est classé comme non correctement adapté si des écarts supérieurs à une valeur seuil de valeur moyenne apparaissent.

4. Procédé selon la revendication 3, **caractérisé en ce que** les étapes de procédé a) à d) sont exécutées pour plusieurs câbles de longueurs différentes, dans lequel les étapes a) à d) sont exécutées au moins deux fois pour chacun des câbles (300), dans lequel, lors de l'étape de procédé b), des impédances terminales différentes sont déterminées, et lors de l'évaluation à l'étape de procédé e), les différences entre les densités spectrales de puissance moyennes des spectres de densité spectrale de puissance définis pour des longueurs de câbles différentes, mais avec des impédances terminales identiques, sont comparées pour au moins deux des impédances terminales déterminées différemment, et si ces différences entre les valeurs moyennes sont égales dans les limites d'une tolérance, mais différentes de zéro, l'impédance terminale de l'étage de sortie à vérifier est estimée à partir de la différence en convertissant la différence en un facteur et en la multipliant par l'impédance des câbles.

5. Procédé selon l'une des revendications précédentes,
**caractérisé en ce que** la fixation de l'impédance terminale à une valeur adaptée à l'impédance des câbles est effectuée par le fait qu'une ligne connectée au câble correspondant dans le dispositif de vérification ou au niveau de celui-ci est terminée par une résistance terminale ohmique dont l'impédance correspond à une impédance de ligne des câbles, ou par le fait que le câble correspondant dans le dispositif de vérification ou au niveau de celui-ci est connecté à un circuit d'étage de sortie d'une unité d'émission et de réception haute fréquence (40) qui est correctement adaptée en termes d'impédance sur toute la bande de fréquences utilisée pour la communication par courants porteurs en ligne et qui est atténuée en ce qui concerne son propre rayonnement pendant la réception du signal haute puissance de l'étage de sortie (545) à vérifier.

6. Procédé selon l'une des revendications précédentes,
**caractérisé en ce que** les différentes impédances déterminées à l'étape de procédé b) comprennent une impédance infinie qui est déterminée en ouvrant la ligne (120) connectée au câble (300) correspondant dans le dispositif de vérification ou au niveau de celui-ci.

7. Procédé selon l'une des revendications précédentes,
**caractérisé en ce que** les câbles (300) sont pourvues de lignes à deux fils (305) pour la communication par courants porteurs en ligne **et en ce que** l'impédance des câbles (300) est respectivement de 100 ohms.

8. Procédé selon l'une des revendications précédentes,
**caractérisé en ce qu'**un signal est transmis à l'étage de sortie (545) à vérifier pour une communication à large bande et haute fréquence par courants porteurs en ligne afin de déclencher l'émission du signal haute fréquence à large bande qui est généré avec une densité spectrale de puissance constante dans chaque bande de fréquences du signal haute fréquence à large bande utilisée pour la communication haute fréquence.

9. Dispositif de vérification (100) permettant de vérifier des étages de sortie (545), en particulier de véhicules électriques ou de stations de recharge (500), pour une communication à large bande et à haute fréquence par courants porteurs en ligne par l'intermédiaire de câbles (300), comprenant :
un raccord de câble (110) permettant de raccorder une extrémité de l'un des câbles (310) qui est connecté au moyen d'une autre extrémité à l'étage de sortie (545) à vérifier ;
un appareil de terminaison de câble (120) connecté au raccord de câble (110), permettant de définir une résistance terminale de la ligne (120) connectée au raccord de câble (110) au niveau du dispositif de vérification ou dans celui-ci ;
un appareil d'échantillonnage (150) connecté au raccord de câble (110) et permettant d'échantillonner le signal haute fréquence à large bande transmis sur l'un des câbles (310) conformément au théorème d'échantillonnage de Nyquist-Shannon et de détecter au moins un transitoire temporel, ces deux étapes étant effectuées pendant la transmission du signal haute fréquence à large bande ;
une unité de calcul (170) permettant de définir un spectre de densité spectrale de puissance associé à l'un des câbles (310) à l'aide de l'au moins un transitoire temporel détecté à l'aide de l'un des câbles (310), et
un appareil d'analyse (200) permettant d'analyser une ou plusieurs bandes de fréquences (3050) du spectre de densité spectrale de puissance (3100-x), dans lequel, lors de l'analyse, on vérifie si des écarts apparaissent dans une ou plusieurs bandes de fréquences (3050) du spectre de densité spectrale de puissance (3100-x) par rapport à un spectre de densité spectrale de puissance attendu ou détecté lors d'une communication avec un étage de sortie correctement adapté en termes d'impédance, et
un appareil de sortie (280) qui délivre en sortie le résultat de l'analyse, lequel délivre en sortie au moins une indication précisant si l'adaptation d'impédance de l'étage de sortie (545) à vérifier est correcte ou incorrecte.

10. Dispositif de vérification (100) selon la revendication 9,
**caractérisé en ce que** l'appareil de terminaison de câble (130) comprend une résistance terminale ohmique (145) qui correspond à l'impédance des câbles.

11. Dispositif de vérification (100) selon la revendication 10,
**caractérisé en ce que** l'appareil de terminaison de câble comprend un appareil de commutation pour terminer la ligne dans le dispositif de vérification ou au niveau de celui-ci par la résistance terminale dont l'impédance correspond à l'impédance des câbles (300), ou pour la commuter vers un état ouvert afin de simuler une impédance infinie, ou pour la connecter à un étage de sortie correctement adapté en termes d'impédance d'une unité d'émission et de réception haute fréquence (40) d'un appareil de communication par courants porteurs en ligne (30), afin d'assurer une adaptation optimale de la terminaison de câble.

12. Dispositif de vérification (100) selon l'une des revendications 9 à 11, **caractérisé en ce que** le dispositif de vérification fait partie d'un appareil de communication par courants porteurs en ligne (30).

13. Dispositif de vérification (100) selon l'une des revendications 9 à 12, **caractérisé en ce qu'**il est configuré pour exécuter le procédé selon les revendications 1 à 8.

14. Système (500) permettant de vérifier des étages de sortie (545), en particulier de véhicules électriques ou de stations de recharge (500), pour une communication à large bande et à haute fréquence par courants porteurs en ligne, en ce qui concerne leur adaptation d'impédance, comprenant le dispositif de vérification (100) selon l'une des revendications 9 à 13, et au moins un câble (300), de préférence plusieurs câbles (300, 310, 320) de longueurs différentes, adaptés en termes d'impédance à l'unité d'émission et de réception haute fréquence (40) du dispositif (100), pour la communication par courants porteurs en ligne pour la connexion à l'un des étages de sortie (545) à vérifier.
